(19) Europäisches Patentamt
European Patent Office
Office européen des brevets

(11) EP 1 603 702 B1

(12) **EUROPEAN PATENT SPECIFICATION**

(45) Date of publication and mention of the grant of the patent:
**22.01.2014 Bulletin 2014/04**

(21) Application number: **04708960.2**

(22) Date of filing: **06.02.2004**

(51) Int Cl.:
***B23K 31/00*** *(2006.01)* ***B23K 20/02*** *(2006.01)*
***C04B 37/00*** *(2006.01)* ***C04B 37/02*** *(2006.01)*

(86) International application number:
**PCT/US2004/002006**

(87) International publication number:
**WO 2004/071700 (26.08.2004 Gazette 2004/35)**

(54) **BONDING METHOD FOR ROOM TEMPERATURE METAL DIRECT BONDING**

VERBINDUNGSVERFAHREN ZUM DIREKTEN BINDEN VON METALL BEI RAUMTEMPERATUR

METHODE D'ASSEMBLAGE POUR COLLAGE DIRECT DE METAUX A TEMPERATURE AMBIANTE

(84) Designated Contracting States:
**AT BE BG CH CY CZ DE DK EE ES FI FR GB GR HU IE IT LI LU MC NL PT RO SE SI SK TR**

(30) Priority: **07.02.2003 US 359608**

(43) Date of publication of application:
**14.12.2005 Bulletin 2005/50**

(73) Proprietor: **Ziptronix, Inc.**
**Morrisville, NC 27560 (US)**

(72) Inventors:
- **TONG, Qin-Yi**
  **Durham, NC 27707 (US)**
- **ENQUIST, Paul, M.**
  **Cary, NC 27513 (US)**
- **ROSE, Anthony, Scot**
  **Cary, NC 27519 (US)**

(74) Representative: **Reitstötter - Kinzebach Patentanwälte**
**Sternwartstrasse 4**
**81679 München (DE)**

(56) References cited:

**EP-A- 0 465 227**
**WO-A-03/054954**
**US-A- 4 818 728**
**US-A- 4 818 728**
**US-A- 4 904 328**
**US-A1- 2002 173 120**
**US-B1- 6 322 600**

- **TONG Q-Y ET AL: "LOW TEMPERATURE WAFER DIRECT BONDING" JOURNAL OF MICROELECTROMECHANICAL SYSTEMS, IEEE SERVICE CENTER, PISCATAWAY, NJ, US, vol. 3, no. 1, 1 March 1994 (1994-03-01), pages 29-36, XP000885425 ISSN: 1057-7157**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

The present invention relates to the field of direct wafer bonding, preferably at room temperature, and more particularly to a bonding method according to the preamble of claim 1 (see, for example, US4 818 728), for substrates to be utilized in semiconductor device and integrated circuit fabrication.

Description of the Related Art

As the physical limits of conventional CMOS device are being approached and the demands for high performance electronic systems are imminent, system-on-a chip (SOC) is becoming a natural solution of the semiconductor industry. For system-on-a chip preparation, a variety of functions are required on a chip. While silicon technology is the mainstay technology for processing a large number devices, many of the desired circuit and optoelectronic functions can now best be obtained from individual devices and/or circuits fabricated in materials other than silicon. Hence, hybrid systems which integrate non-silicon based devices with silicon based devices offer the potential to provide unique SOC functions not available from pure silicon or pure non-silicon devices alone.

One method for heterogeneous device integration has been the hetero-epitaxial growth of dissimilar materials on silicon. To date, such hetero-epitaxial growth has realized a high density of defects in the hetero-epitaxial grown films, largely due to the mismatches in lattice constants between the non-silicon films and the substrate.

Another approach to heterogeneous device integration has been wafer bonding technology. However, wafer bonding of dissimilar materials having different thermal expansion coefficients at elevated temperature introduces thermal stresses that lead to dislocation generation, debonding, or cracking. Thus, low temperature bonding is desired. Low temperature bonding is also crucial for the bonding of dissimilar materials if the dissimilar materials include materials with low decomposition temperatures or temperature sensitive devices such as for example an InP heterojunction bipolar transistor or a processed Si device with ultrashallow source and drain profiles.

The design of processes needed to produce different functions on the same chip containing different materials is difficult and hard to optimize. Indeed, many of the resultant SOC chips (especially those at larger integration size) show a low yield. One approach has been to interconnect fully processed ICs by wafer adhesive bonding and layer transfer. See for example Y. Hayashi, S. Wada, K. Kajiyana, K. Oyama, R. Koh, S Takahashi and T. Kunio, Symp. VLSI Tech. Dig. 95 (1990) and U.S. Patent 5,563,084, the entire contents of both references are incorporated herein by reference. However, wafer adhesive bonding usually operates at elevated temperatures and suffers from thermal stress, out-gassing, bubble formation and instability of the adhesive, leading to reduced yield in the process and poor reliability over time. Moreover, adhesive bond is usually not hermetic.

Wafer direct bonding is a technology that allows wafers to be bonded at room temperature without using any adhesive. The room temperature direct wafer bond is typically hermetic. It is not prone to introduce stress and inhomogeneity as in the adhesive bonding. Further, if the low temperature bonded wafer pairs can withstand a thinning process, when one wafer of a bonded pair is thinned to a thickness less than the respective critical value for the specific materials combination, the generation of misfit dislocations in the layer and sliding or cracking of the bonded pairs during subsequent thermal processing steps are avoided. See for example Q.-Y. Tong and U. Gösele, Semiconductor Wafer Bonding: Science and Technology, John Wiley & Sons, New York, (1999), the entire contents of which are incorporated herein by reference.

Moreover, wafer direct bonding and layer transfer is a VLSI (Very Large Scale Integration) compatible, highly flexible and manufacturable technology, using that to form stacking three-dimensional system-on-a chip (3-D SOC) is highly preferable. The 3-D SOC approach can be seen as the integration of existing integrated circuits to form a system on a chip.

Moreover, as the integration complexity grows, so do the demands on the integration process to robustly unify diverse circuits at low temperature, preferably at room temperature resulting in lower or non additional stress and more reliable circuits.

Low or room temperature direct wafer bonding of metal between wafers or die being bonded is desirable for 3D-SOC preparation because this can be used in conjunction with direct wafer bonding of non-metal between wafers or die to result in electrical interconnection between wafers or die being bonded when they are mechanically bonded and thus eliminate the need to for post-bond processing, like substrate thinning, via etching, and interconnect metalization, to achieve an electrical interconnection between bonded wafers or die. Very small bonding metal pads can be used resulting in very low parasitics and resulting reduced power and increased bandwidth capability.

Bonding of metals with clean surfaces is well-known phenomenon. For example, thermocompression wire bonding has been applied to wafer-level bonding. Temperature, pressure and low hardness metals are typically employed and usually results in residual stresses. For example, see example, M.A. Schmidt, Proc. IEEE, Vol. 86, No. 8, 1575 (1998), Y. Li, R.W. Bower, I. Bencuya, Jpn. J. Appl. Phys. Vol. 37, L1068 (1988). Direct bonding of Pd metal layer covered silicon or III V compound wafers at 250-350°C has been reported by B. Aspar, E. Jalaguier, A. Mas, C. Locatelli, O. Rayssac, H. Moricean, S. Pocas, A. Papon, J. Michasud and M. Bruel, Electon. Lett., 35, 12 (1999). However, actually $Pd_2Si$ silicide or Pd-III V alloys, not metal Pd, are formed and bonded. Bonding of Au and A1 at room temperature has been achieved by using ultrasonic and compressive load at flip chip bonding, see example, M. Hizukuri, N. Watanabe and T. Asano, Jpn. J. Appl. Phys. Vol. 40, 3044 (2001). Room temperature metal bonding at wafer level has been realized in ultrahigh vacuum (UHV) systems with a base pressure lower than $3x10^{-8}$ mbar. Usually an ion argon sputtering or fast atom-beam is used to clean the bonding surfaces followed by application of an external pressure to the bonding substrates. See for example, T. Suga, Proc. The 2nd Intl. Symposium on semiconductor wafer bonding, the Electrochemical Soc. Proc. Vol. 93-29, p.71 (1993). Room temperature bonding between two Si substrates with thin sputtered Ti, Pt and Au films has also been accomplished using applied force after thin film sputter deposition at 4-40 μbar of Ar pressure in a UHV system with base pressure less than $3x\ 10^{-8}$ mbar. See for example, T. Shimatsu, R.H. Mollema, D. Monsma, E.G. Keim and J.C. Lodder, J. Vac. Sci. Technol. A 16(4), 2125 (1998).

US 4,818,728 describes a method of making a hybrid semiconductor device. According to this method, a plurality of connecting electrodes are formed on an upper surface of an IC substrate and a protective layer is subsequently formed entirely over the upper surface of the substrate so as to cover the connecting electrodes. Subsequently, portions of the protective layer are perforated in a depth sufficient to permit the respective electrodes to be exposed to the outside through the resultant perforations. Then conductor pieces are inserted through the perforations. Subsequently, a resinous bonding agent having an electrically insulating property is applied over the protective layer to form a bonding layer overlaying the conductor pieces. The bonding layer is then etched off until respective upper regions of the conducting pieces are exposed to complete a single semiconductor IC unit. Then another semiconductor IC unit having corresponding substrate, electrodes, protective layer, conductive pieces and bonding layer is formed and is placed over the other substrate with the conductor pieces in the semiconductor unit exactly aligned with the conductor pieces of both units. Subsequently, the assembly is hot-pressed to allow the bonding layers to be bonded together.

US 2002/0173120 A1 describes a three-dimensional device integration method. The method includes the steps of polishing surfaces of first and second workpieces each to a surface roughness of about 5-10 Å. The polished surfaces of the first and second workpieces are bonded together. The surface of a third workpiece is polished is polished to the surface roughness. The surface of the third workpiece is bonded to the joint first and second workpieces. The manner of bonding in this method may be direct bonding without the use of applied pressure, voltage or temperature.

## SUMMARY OF THE INVENTION

An object of the present invention is thus to obtain mechanical and electrical contact between wafers and die with a single bonding step.

According to the invention this object is achieved by a bonding method comprising the features of claim 1. Further embodiments of this method are described by the features of the dependent claims.

Another object of the present invention is to provide a low or room temperature bonding method by which metallic bonding between wafers or die of semiconductor circuits can be formed in ambient without using external pressure.

An additional object of the present invention is to provide a low or room temperature bonding method by which metallic bonding of layers of any metal between wafers or die of semiconductor circuits can be formed at room temperature at wafer level in ambient without using external pressure by covering metal layers with a thin film of gold or copper or palladium.

Still another object of the present invention is to provide a room temperature bonding method at wafer level in ambient without using external pressure by which metallic as well as covalent bonds are formed simultaneously at room temperature on bonding surfaces of wafers or die comprised of semiconductor circuits where metal and other non-metal layers co-exist.

Another object is to provide a room temperature bonding method by which different substrates or different materials on different substrates with different thermal expansion coefficients can be bonded together without generation of catastrophic stresses between the different substrates or different materials on different substrates.

Still another object of the present invention is a room temperature bonding method by which the bond strength between substrates approaches the mechanical fracture strength of the substrates.

Another object of the present invention is to provide a bonded device structure including devices fabricated individually on separate substrates and bonded on a common substrate.

A still further object of the present invention is to provide a method and device whereby a reliable mechanical bond can be formed at or near room temperature and a reliable electrical contact can be subsequently formed with a simple low temperature anneal.

BRIEF DESCRIPTION OF THE DRAWINGS

A more complete appreciation of the present invention and many attendant advantages thereof will be readily obtained as the same becomes better understood by reference to the following detailed description when considered in connection with the accompanying drawings, wherein:

FIG. 1A is a schematic depiction of a pair of unbonded substrates having aligned metal bonding pads;
FIG. 1B is a schematic depiction of a pair of unbonded substrates having the aligned metal bonding pads contacted;
FIG. 1C is a schematic depiction of a pair of contacted substrates, according to the present invention, bonded in a non-metal region away from the metal bonding pads;
FIG. 1D is a schematic depiction of a pair of contacted substrates, according to the present invention, bonded across the non-metal regions except for a small unbonded ring area near the metal bonding pads;
FIGS. 2A-2C are schematic diagrams illustrating bonding substrates with multiple bonding pads;
FIG. 2D is graph, according to the present invention showing the width of an unbonded ring area W as a function of the metal pad thickness 2h separating the semiconductor dies as shown in the insert;
FIG. 3A is a schematic depiction of semiconductor die or wafer after surface planarization;
FIG. 3B is a schematic depiction of semiconductor die or wafer in which second metal layer are formed and planarized with contact windows opened on metal pads ;
FIG. 3C is a schematic depiction of second semiconductor die or wafer with a second metal layer.
FIG. 3D is a schematic depiction of an aligned metal bonding of two dies or wafers, according to the present invention;
FIG. 4A is a schematic depiction of a part of a substrate showing imbedded metal pads in an oxide coating;
FIG. 4B is a schematic depiction of a pair of unbonded substrates, according to the present invention, having reciprocal metal bonding pads;
FIG. 4C is a schematic depiction of a pair of bonded substrates, according to the present invention, showing the reciprocal metal bonding pads contacted by the forces generated when the non-metal regions contacted and bonded;
FIG. 4D is a schematic depiction of a pair of smaller substrates bonded to a larger substrate;
FIG. 5A is a schematic diagram of an embodiment of the invention having a deformable material or void beneath the metal pad;
FIG. 5B is a schematic diagram of an embodiment of the invention having a deformable material beneath the metal pad;
FIG. 5C is a schematic diagram of two devices as shown in FIG. 5A bonded together.
FIG. 6A is a schematic diagram of an embodiment of the invention having reflowable metal material exposed to the surface on two devices prior to direct wafer bonding of the non-metal surfaces.
FIG. 6B is a schematic diagram of an embodiment of the invention having reflowable metal material sealed by after direct wafer bonding of the non-metal surfaces.
FIG 6C is a schematic diagram of an embodiment of the invention having reflowable metal reflowed after direct wafer bonding of non-metal surfaces sealed the reflowable metal.
FIG. 7A is a schematic diagram of an embodiment of the invention having reflowable metal material exposed to the surface on two devices prior to direct wafer bonding of the non-metal surfaces.
FIG. 7B is a schematic diagram of an embodiment of the invention having reflowable metal material sealed by after direct wafer bonding of the non-metal surfaces.
FIG 7C is a schematic diagram of an embodiment of the invention having reflowable metal reflowed after direct wafer bonding of non-metal surfaces sealed the reflowable metal.
FIGS. 8 and 9 are graphs of room temperature bonding energy versus storage time;

DETAILED DESCRIPTION OF THE PREFERRED EMBODIMENTS

Referring now to the drawings, wherein like reference numerals designate like or corresponding parts throughout the several views, and more particularly to FIGS. 1A -1D and 2 illustrating a first embodiment of the bonding process of the present invention. In the first embodiment of the present invention, direct metal-metal bonding is generated when metal contact regions on separate wafers upon alignment are contact pressure bonded by the intrinsic forces generated when non-metallic regions peripheral to the metallic regions undergo room-temperature chemical bonding. Chemical bonding, according to the present invention, as used throughout this specification is defined as a bond strength developed when surface bonds on the surface of one wafer react with the surface bonds on the surface of an opposing wafer to form direct bonds across the surface elements, such as a covalent bond. Chemical bonds are manifest by their high bond strengths, approaching for instance the fracture strength of the wafer materials, and thus are differentiated for example from mere Van der Waals bonding. Examples of chemical bond strengths achieved by the methods of the present invention are discussed below. In the chemical bonding process, substantial forces are developed. These forces can be sufficiently great to elastically deform the metallic regions as the chemical bond propagates between the opposed non-metallic regions.

FIG. 1A shows two wafers 10, 13 with respective opposing wafer surfaces 11, 14. The wafer surfaces may be pure elemental semiconductor surfaces, may be pure elemental semiconductor surfaces including a relatively small amount of native oxide, or may be an insulator such as oxide-coated surface. The surfaces may be prepared to produce a smooth, activated surface. Techniques such as polishing or polishing and very slightly etching (VSE) may be used. A bonding layer may be deposited and polished or polished and slightly etched. The resulting surfaces are complementary and have chemical bonding surfaces that are planar and smooth, having chemical bonding surface roughness in the range of 5-15Å, preferably no more than 10 Å, and more preferably no more than 5 Å.

In more detail, for the example of the bonding layer, the bonding layer may be any solid state material or mixed materials which can be deposited or formed at low temperatures and can be polished to a sufficiently smooth surface. The bonding layer may be an insulator, such as $SiO_2$, silicon nitride, amorphous silicon formed using chemical vapor deposition (CVD) or plasma-enhanced CVD (PECVD), sputtering or by evaporation. Other materials such as polymers, semiconductors or sintered materials may also be used. The bonding layer should have thickness greater than the surface topography of the layer on which it is formed. Preferably, the bonding layer is a deposited silicon oxide.

The surface of the bonding layer is planarized and smoothed. This step may be accomplished using chemical-mechanical polishing. The surface is preferably polished to a roughness described above and is substantially planar. After polishing the surface may be cleaned and dried to remove any residue from the polishing step. The polished surface is preferably then rinsed with a solution.

The bonding surface may also be etched prior to polishing to improve the planarity and/or surface roughness. The etching can be effective to remove high spots on the bonding surface by selective etching of the high spots using, for example, standard photolithographic techniques. For example, a layer of silicon nitride can be embedded within a silicon dioxide bonding layer that can serve as an etch stop when using a solution containing HF. The etch stop material may be used to improve uniformity, reproducibility, and manufacturability.

The surface then undergoes an activation process. This activation process is an etching process and preferably a very slight etch (VSE) process. The term VSE means that the root-mean-square micro-roughness (RMS) of the very slightly etched surface remains at approximately the unetched value, in the ranges described above. The optimum amount of material removed depends upon the material and the method used for removal. Typical amounts removed vary from Angstroms to a few nanometers. It is also possible to remove more material. VSE also includes the breaking of bonds on the treated surfaces and can occur without significant removal of material. The VSE is distinct from simple modification of the surface by, for example, charging the surface with electronic charge or damaging the surface layer. In a first example of the method according to the invention, the VSE process consists of a gas or mixed gas (such as oxygen, argon, nitrogen, $CF_4$, $NH_3$) plasma process at a specified power level for a specified time. The power and duration of the plasma process will vary depending upon the materials used to obtain the desired bond energy. Examples are given below, but in general, the power and duration will be determined empirically.

The plasma process may be conducted in different modes. Both reactive ion etch (RIE) and plasma modes may be used, as well as an inductively-coupled plasma mode (ICP). Sputtering may also be used. Data and examples are given below in both the RIE and plasma modes.

The VSE process etches the surface very slightly via physical sputtering and/or chemical reaction and preferably is controlled to not degrade the surface roughness of the bonding surfaces. The surface roughness may even be improved depending upon the VSE and materials etched. Almost any gas or gas mixture that will not etch the surface excessively can be used for the room temperature bonding method according to the invention.

The VSE serves to clean the surface and break bonds of the oxide on the wafer surface. The VSE process can thus enhance the surface activation significantly. A desired bonding species can be used to terminated on the surface during the VSE by proper design of the VSE. Alternatively, a post-VSE treatment that activates and terminates the surface with a desired terminating species during the post-VSE process may be used.

The desired species further preferably forms a temporary bond to the surface atomic layer, effectively terminating the atomic layer, until a subsequent time that this surface can be brought together with a surface terminated by the same or another bonding species. Desired species on the surfaces will further preferably react with each other when they are in sufficiently close proximity allowing chemical bonding between surfaces at low or room temperature that is enhanced by diffusion or dissociation and diffusion of the reacted desired species away from the bonding interface.

The post-VSE process preferably consists of immersion in a solution containing a selected chemical to generate surface reactions that result in terminating the bonding surface with desired species. The immersion is preferably performed immediately after the VSE process. The post-VSE process may be performed in the same apparatus in which the VSE process is conducted. This is done most readily if both VSE and post-VSE processes are either dry, i.e, plasma, RIE, ICP, sputtering, etc, or wet, i.e., solution immersion. A desired species preferably consists of a monolayer or a few monolayers of atoms or molecules.

The post-VSE process may also consist of a plasma, RIE, or other dry process whereby appropriate gas chemistries are introduced to result in termination of the surface with the desired species. The post-VSE process may also be a second VSE process. The termination process may also include a cleaning process where surface contaminants are removed without VSE. In this case, a post-cleaning process similar to the post-VSE processes described above then results in a desired surface termination.

The post-VSE or post-cleaning process may or may not be needed to terminate surfaces with desired species if the activated surface bonds by the cleaning or VSE process are subsequently sufficiently weakly surface reconstructed and can remain sufficiently clean before bonding such that subsequent bonding with a similar surface can form a chemical bond.

The wafers are optionally rinsed then dried. Two wafers are bonded by aligning them (if necessary) and bringing them together to form a bonding interface. A spontaneous bond then typically occurs at some location in the bonding interface and propagates across the wafer. As the initial bond begins to propagate, a chemical reaction such as polymerization that results in chemical bonds takes place between species used to terminate surfaces when the surfaces are in sufficient proximity. The bonding energy is defined as the specific surface energy of one of the separated surfaces at the bonding interface that is partially debonded by inserting a wedge. The by-products of the reaction then diffuse away from the bonding interface to the wafer edge or are absorbed by the wafers, typically in the surrounding materials. The by-products may also be converted to other by-products that diffuse away or are absorbed by the wafers. The amount of covalent and/or ionic bonding may be increased by removal of converted species resulting in further increase in bond strength.

The materials of the bonding layers preferably have an open structure so that the by-products of the polymerization reaction can be easily removed. The bonding species on the opposing bonding surfaces must be able to react at room temperature to form a strong or chemical bond. The bond energy is sufficiently high to virtually eliminate slippage between wafers after subsequent heat treatments associated with a subsequent processing or operation when wafers have different thermal expansion coefficients. Lack of slippage is manifest by a lack of wafer bowing upon inspection after the subsequent processing or operation.

The bonded wafers are preferably stored at ambient or at low or room temperature after bonding to allow removal of species or converted species for a specified period of time depending upon the materials and species used. Twenty four hours is usually preferable.

The storage time is dependent upon the type of plasma process used. Chemical bonds may be obtained more quickly, in a matter of minutes, when certain plasma processes such as an Ar plasma are used. For example, 585 $mJ/m^2$ bonds were obtained in immediately after bonding and over 800 mJ/m2 were observed after 8 hours for deposited oxides etched by an Ar plasma followed by $NU_4OH$ dip.

Annealing the bonded wafers during bonding may increase the bonding strength. The annealing temperature should be below 200° C and may be typically in the range of 75-100° C. Storing the bonded wafers under vacuum may facilitate the removal of residual gasses from the bonding surfaces, but is not always necessary.

All of the processes above may be carried out at or near room temperature. The wafers are bonded with sufficient strength to allow subsequent processing operations (lapping, polishing, substrate removal, chemical etching, lithography, masking, etc.). Bonding energies of approximately 500-2000 $mJ/m^2$ or more can be achieved (see FIG. 8).

In an example, $SiO_2$ is deposited on a Si wafer containing devices. The surface, after the plasma (such as argon, oxygen or $CF_4$) treatment, is mainly terminated by Si-OH groups due to the availability of moisture in the plasma system and in air. After the plasma treatment, the wafers are immediately immersed in solution such as ammonium hydroxide ($NH_4OH$), $NH_4F$ or HF for a period such as between 10 and 120 seconds. After immersing the wafers in the $NH_4OH$ solution, many Si-OH groups are replaced by Si-NH2 groups according to the following substitution reaction:

$$2Si\text{-}OH + 2NH_4OH \rightarrow 2Si\text{-}NH_2 + 4HOH \qquad (1)$$

Alternatively, many Si-F groups are terminating on the PECVD $SiO_2$ surface after an $NH_4F$ or HF immersion.

The hydrogen bonded Si-NH2:Si-OH groups or Si-NH2:Si-NH2 groups across the bonding surfaces can polymerize at room temperature in forming Si-O-Si or Si-N-N-Si (or Si-N-Si) covalent bonds:

$$Si\text{-}NH2 + Si\text{-}OH \rightarrow Si\text{-}O\text{-}Si + NH_3 \qquad (2)$$

$$Si\text{-}NH2 + Si\text{-}NH_2 \rightarrow Si\text{-}N\text{-}N\text{-}Si + 2H2 \qquad (3)$$

Alternatively, the HF or $NH_4F$ dipped oxide surfaces are terminated by Si-F groups in addition to Si-OH groups. Since HF or $NH_4F$ solution etches silicon oxide strongly, their concentrations must be controlled to an adequately low level, and the immersion time must be sufficiently short. This is an example of a post-VSE process being a second VSE process. The covalent bonds across the bonding interface are formed due to the polymerization reaction between hydrogen bonded Si-HF or Si-OH groups:

$$\text{Si-HF + Si-HF} \rightarrow \text{Si-F-F-Si + H2} \qquad (4)$$

$$\text{Si-F + Si-OH} \rightarrow \text{Si-O-Si + HF} \qquad (5)$$

FIG. 9 shows the fluorine concentration profile of bonded thermal oxide covered silicon wafers that were dipped in 0.05% HF before room temperature bonding. A fluorine concentration peak is clearly seen at the bonding interface. This provides evidence of the chemical process described above where the desired species are located at the bonding interface.

Since reaction (2) is reversible only at relatively high temperatures of ~500° C, the formed siloxane bonds should not be attacked by $NH_3$ at lower temperatures. It is known that $H_2$ molecules are small and diffuse about 50 times quicker than water molecules in oxide. The existence of a damaged layer near the surface of an adequate thickness i.e. a few nm, will facilitate the diffusion or dissolution of $NH_3$, and HF and hydrogen in reactions (2), (3), (4) and/or (5) in this layer and enhancement of the chemical bond. The three reactions result in a higher bonding energy of $SiO_2/SiO_2$ bonded pairs at room temperature after a period of storage time to allow $NH_3$ or $H_2$ to diffuse away.

In this example, the plasma treatment may create a damaged or defective area in the oxide layer near the bonding surface. The zone extends for a few monolayers. The damaged or defective area aids in the removal of bonding by-products. Efficient removal of the bonding by-products improves the bonding strength since the by-products can interfere with the bonding process by preventing high-strength bond from forming.

Many different surfaces of materials may be smoothed and/or planarized, followed by a cleaning process, to prepare for bonding according to the invention. These materials can be room temperature bonded by mating surfaces with sufficient planarity, surface smoothness, and passivation that includes cleaning, and/or VSE, activation and termination. Amorphous and sintered materials, non-planar integrated circuits, and silicon wafers are examples of such materials. Single crystalline semiconductor or insulating surfaces, such as $SiO_2$ or Si surfaces, can also be provided with the desired surface roughness, planarity and cleanliness. Keeping the surfaces in high or ultra-high vacuum simplifies obtaining surfaces sufficiently free of contamination and atomic reconstruction to achieve the strong bonding according to the invention. Other semiconductor or insulator materials such as InP, GaAs, SiC, sapphire, etc., may also be used. Also, since PECVD $SiO_2$ may be deposited on many types of materials at low temperatures, many different combinations of materials may be bonded according to the invention at room temperature. Other materials may also be deposited as long as appropriate processes and chemical reactions are available for the VSE, surface activation, and termination.

If a relatively thick (~5 nm) oxide layer is formed, it will take a long period of time for the water molecules to diffuse through this thick layer. On the other hand, if after the plasma treatment a thin oxide layer is left or a too narrow defective zone is formed, water that can reach the silicon surface may not react sufficiently with the silicon and convert to hydrogen. In both cases the bonding energy enhancement will be limited. The preferred oxygen plasma treatment thus leaves a minimum plasma oxide thickness (e.g., about 0.1-1.0 nm) and a reasonably thick defective zone (e.g., about 0.1-0.3 nm) on the silicon surface.

In a second embodiment, the VSE process uses wet chemicals. For example, an InP wafer having a deposited silicon oxide layer, as in the first embodiment, and a device layer are bonded to a AlN substrate having a deposited oxide layer. After smoothing and planarizing the InP wafer bonding surface and the AlN wafer bonding surface, both wafers are cleaned in an standard RCA cleaning solution. The wafers are very slightly etched using a dilute HF aqueous solution with an HF concentration preferably in the range of 0.01 to 0.2%. About a few tenths of a nm is removed and the surface smoothness is not degraded as determined by AFM (atomic force microscope) measurements. Without deionized water rinse, the wafers are spin dried and bonded in ambient air at room temperature. The resulting bonding energy has been measured to reach ~700 $mJ/m^2$ after storage in air. After annealing this bonded pair at 75°C the bonding energy of 1500 $mJ/m^2$ was obtained., The bonding energy has been measured to reach silicon bulk fracture energy (about 2500 $mJ/m^2$) after annealing at 100°C. If the wafers are rinsed with deionized water after the HF dip, the bonding energy at 100°C is reduced to 200 $mJ/m^2$, that is about one tenth of that obtained without the rinse. This illustrates the preference of F to OH as a terminating species.

In a first example of the bonding, three inch <100>, 1-10 ohm-cm, boron doped silicon wafers were used. PECVD oxide was deposited on some of the silicon wafers. For comparison, thermal oxidized silicon wafers were also studied. The PECVD oxide thickness was 0.5 $\mu$m and 0.3 $\mu$m on the front side and the backside of the wafers, respectively. Oxide is deposited on both sides of the wafer to minimize wafer bow during polishing and improve planarization. A soft polish was performed to remove about 30 nm of the oxide and to smooth the front oxide surface originally having a root mean square of the micro-roughness (RMS) of ~0.56 nm to a final ~0.18 nm. A modified RCA1 solution was used to clean the wafer surfaces followed by spin-drying.

Two wafers were loaded into the plasma system, both wafers are placed on the RF electrode and treated in plasma in RIE mode. For comparison, some wafers were treated in plasma mode in which the wafers were put on the grounded electrode. An oxygen plasma was used with a nominal flow rate of 16 scc/m. The RF power was 20-400 W (typically 80 W) at 13.56 MHz and the vacuum level was 100 mTorr. The oxide covered wafers were treated in plasma for times between 15 seconds to 5 minutes. The plasma treated silicon wafers were then dipped in an appropriate solution or rinse with de-ionized water followed by spin-drying and room temperature bonding in air. Some of the plasma treated wafers were also directly bonded in air without rinse or dipping.

The bonding energy was measured by inserting a wedge into the interface to measure the crack length according to the equation:

$$\gamma = \frac{3t_b^2 E_1 t_{w1}^3 E_2 t_{tw2}^3}{16L^4 (E_1 t_{w1}^3 + E_2 t_{w2}^3)}$$

E and tw are the Young's modulus and thickness for wafers one and two and tb is the thickness of a wedge inserted between the two wafers that results in a wafer separation of length L from the edge of the wafers.

The room temperature bonding energy as a function of storage time of bonded plasma treated oxide covered silicon wafers is shown in FIG. 8. This figure shows measured room temperature bonding energy versus storage time for 4 different cases as shown. The results can be summarized as follows: (1) for dipped and bonded RIE plasma treated oxide wafers, the room temperature bonding energy increases with storage time and reaches a stable value after ~20 h in air or at low vacuum; (2) RIE mode results in higher bonding energies than plasma mode; (3) too short a plasma exposure time or too low a plasma power provides a small or negligible increase in bond energy; (4) $NH_4OH$ dip after plasma treatment shows a much higher increase in bonding energy than water rinse; (5) direct bonding in air after plasma treatment without dipping or rinse shows an almost constant bonding energy with time. The bonding energy of the directly bonded wafer pairs immediately after room temperature bonding is slightly higher than the de-ionized water rinsed or $NH_4OH$ dipped wafer pairs.

FIG. 9 shows room temperature bonding of Si and AlN wafers with PECVD oxide deposited layers. After about 100 h of storage time a bonding energy of over 2000 mJ/m$^2$ were observed.

Comparing different bonding materials, the bonding energy as a function of storage time of $O_2$ plasma treated thermally oxidized silicon wafer pairs is similar to wafers with PECVD oxide, although the values of the room temperature bonding energy are somewhat lower.

After ~24 h storage in air at room temperature, the bonding energy as high as ~1000 mJ/m2 was reached in the RIE mode plasma treated and $NH_4OH$ dipped PECVD oxide covered wafer pairs. Since the maximum bonding energy of a van der Waals bonded silicon oxide covered wafer pairs is about 200 mJ/m2, a large portion of the bonding energy is attributed to the formation of covalent bonds at the bonding interface at room temperature according to the above equation.

Surfaces are sputter etched by energetic particles such as radicals, ions, photons and electrons in the plasma or RIE mode. For example, the $O_2$ plasma under conditions that bring about the desired VSE is sputter-etching about 2 Å /min of PECVD oxide as measured by a reflectance spectrometry. For thermal oxide the sputter etching rate is about 0.5 Å/min. The thickness of oxide before and after plasma treatment was measured by a reflectance spectrometry and averaged from 98 measured points on each wafer. The etching by $O_2$ plasma has not only cleaned the surface by oxidation and sputtering but also broken bonds of the oxide on the wafer surfaces.

However, the surface roughness of plasma treated oxide surfaces must not be degraded by the etching process. AFM measurements show that compared with the initial surface roughness, the RMS of the $O_2$ plasma treated oxide wafers was ~2 Å and did not change noticeably. On the other hand, if the etching is not sufficiently strong, the bonding energy enhancement effect is also small. Keeping other conditions unchanged when the $O_2$ plasma treatment was performed with plasma mode rather than RIE mode, the etching of oxide surfaces is negligible and the oxide thickness does not change. The final room temperature bonding energy is only 385 mJ/m2 compared to 1000 mJ/m2 of RIE treated wafers (see FIG. 8).

Other gas plasma has shown a similar effect. $CF_4/O_2$ RIE was used to remove ~4 nm of PECVD oxide from the wafer surfaces prior to bonding. The bonding energy of room temperature bonded PECVD oxide covered silicon wafers was also enhanced significantly in this manner and exceeds 1000 mJ/m2 after sufficient storage time (see also FIG. 8).

An argon plasma has also been used for the VSE with a nominal flow rate of 16 scc/m. The RF power was typically 60 W at 13.56 MHz and the vacuum level was 100 mTorr. The oxide covered silicon wafers were treated in plasma in RIE mode for times between 30 seconds to 2 minutes. The plasma treated silicon wafers were then dipped in an $NH_4OH$ solution followed by spin-drying and room temperature bonding in air. The bonding energy reached ~800 mJ/m$^2$ at room temperature after only 8 h storage in air.

Each wafer includes a set of metallic pads 12, 15 and a non-metallic region adjacent to the metallic bonding pads in the surfaces 11, 14. The non-planarity and surface roughness of the metallic bonding pads may be larger than that of the chemical bonding surfaces. Pads 12, 15 may be used to route electrical connections to the respective devices and/or circuits pre-fabricated on the wafers. The pads are preferably formed before surface treatment, and VSE is preferably performed after the pads are formed. As shown in FIG. 1A, pads 12, 15 are on the respective wafers are aligned. FIG. 1B shows the wafers upon placing the wafers together to contact the respective pads. At this stage, pads 12, 15 would be separable. In FIG. 1C, according to the present invention, slight additional pressure is applied to the wafers to elastically deform one or both of the semiconductor wafers, resulting in contact between some of the non-metal areas on the wafers. The location shown of the contacting is an example, and the contact may occur at different locations. Also, the contact may occur at more than one point. This contact initiates chemical wafer-to-wafer bonding, and the bonded structure is shown in FIG. 1D. The bonding seam 16 expands after the initial chemical bonding to produce bonding seam 17 shown in FIG. 1D. The bond strength is initially weak and increases as the bonding propagates, as explained above. The opposing non-metallic regions are chemically bonded at room or low temperature.

In more detail, as the wafer surfaces including the metal bonding pads contact at room temperature, the contacting non-metal parts of opposing wafer surfaces began to form a bond at the contact point or points, and the attractive bonding force between the wafers increases as the contact chemical bonding area increases. Without the presence of the metal pads, the wafers would bond across the entire wafer surface. According to the present invention, the presence of the metal pads, while interrupting the bonding seam between the opposing wafers, does not prohibit chemical wafer to wafer bonding. Due to the malleability and ductility of the metal bonding pads, the pressure generated by the chemical wafer-to-wafer bonding in the non-metal regions may results in a force by which nonplanar and/or rough regions on the metal pads may be deformed resulting in improved planarity and/or roughness of the metal pads and intimate contact between the metal pads. The pressure generated by the chemical bonding is sufficient to obviate the need for external pressure to be applied in order for these metal pads to be intimately contacted to each other. A strong metallic bond can be formed between the intimately contacted metal pads, even at room temperature, due to inter-diffusion or self-diffusion of metal atoms at the mating interface. This diffusion is thermodynamically driven to reduce the surface free energy and is enhanced for metals that typically have high inter-diffusion and/or self-diffusion coefficients. These high diffusion coefficients are a result of a cohesive energy that is typically mostly determined by the mobile free electron gas that is not disturbed by the motion of metal ions during the diffusion The wafer-to-wafer chemical bonding in the non-metal regions thus effects electrical connection between metal pads on the two different wafers. The geometrical and mechanical constraints governing this effect are described below.

An unbonded area around the bonding pad having a width W will be generated in which the non-metal surfaces of the two wafers are precluded from contacting (see FIG. 1D). As long as the thickness of metal films is not too large, the gaps between two bonding wafers or dies can be reduced leaving a small unbonded area around each metal pad. This is illustrated in FIGS. 2A-2C, where wafer 20 with metal pads 21 is ready to be bonded to wafer 22 with pads 23. A gap 24 is between adjacent pads. The metal pads are contacted (FIG. 2B) and the wafers elastically deform, according to the present invention, to bond in the gaps 24 to form bonds 25 (FIG. 2C). It is noted that the dimensions in FIGS. 2A-2C are not to scale.

The formula to calculate the width of the unbonded area as a function of metal film thickness, mechanical properties of the wafer or die, the wafer or die thickness, the bonding energy will be shown below. FIG. 2D is a graph showing the relationship between the gap height 2h and the width w of an unbonded area. When the deformation of the wafers obeys an elastic constant given by Young's modulus E and the wafers each have a thickness of $t_w$, according to the simple theory of small deflection of a thin plate, the width W of the unbonded area can be roughly estimated by the following equation for $W > 2t_w$, where the metal bonding pads as a pair have a height of 2h above the wafer surface:

$$W = [(2E' t_w^3) / (3\gamma)]^{1/4} h^{1/2} \qquad (1)$$

where E' is given by $E/(1-v^2)$ with v being Poisson's ratio.

It has been suggested that with decreasing h, the situation changes drastically. See for example, U. Goesele and Q.-Y. Tong, Proc. The 2nd Intl. Symposium on semiconductor wafer bonding, the Electrochemical Soc. Proc. Vol. 93-29, p.395 (1993). If W calculated by Eq. (1) leads to values below $W_{crit} = 2t_w$, corresponding to $h < h_{crit}$ where $h_{crit} = 5 (t_w\gamma/E')^{1/2}$, then an elastomechanical instability is supposed to occur, leading to an unbonded area with much smaller W that is independent of wafer thickness $t_w$, and is given by:

$$W \approx kh \qquad (2)$$

where k is a dimensionless constant on the order of 1. Experimentally, as shown in Fig. 2D if h < 300 Å, W is much smaller than what is predicted by Eq. (1). Further work by the inventors of the present application has shown that, if the spacing between metal bonding pad pairs 2R is smaller than 2W, the wafer pairs may not bond to each other. However, when 2R > 2W, surfaces between the two unbonded areas around the metal posts will bond and the metal posts will be bonded and electrically connected.

The pressure P on the metal bonding pairs that is generated by the bonding of the surrounding area can be expressed as:

$$P = (16\,E' t_w^3 h)/(3W^4) \qquad (3)$$

Combining Eq.(3) with Eq.(1) or (2), when W > 2 $t_w$, the following is obtained:

$$P = 8\,\gamma\,/3h, \qquad (4)$$

and when W < 2 $t_w$, the following is obtained:

$$P = (16\,E' t_w^3)/\,(3\,k^4 h^3) \qquad (5)$$

For bonded silicon wafers where the metal pads have height h of 500 Å and the bonding energy is 300 $mJ/m^2$, the compressive pressure on the metal bonding pads is about $1.6 \times 10^8$ $dynes/cm^2$, i.e. 160 atmospheres. Since this pressure is sufficiently high for metal bonding, there is no need to apply any external pressure during bonding. When metal height h is 300 Å or less, $W < 2t_w$ is satisfied and the pressure on the metal pairs is in the order of 5000 atmospheres if k =1 is assumed.

In one example of the first embodiment of the present invention, 5 mm diameter Au bonding pads with a thickness less than 300 Å and a separation distance of 1 mm were deposited on oxide covered 100 mm silicon wafers. Since the Au bonding pads were formed on the surface of the oxide, they also had a height of 300 Angstroms above the surface of the oxide. However, h can be much smaller than actual metal thickness since metal cam be partially buried in oxide or other insulator and h is the height the metal extended above the die surface. A room temperature bonding technology has been developed that cleans and activates the metal and the oxide surfaces compatibly and simultaneously. The Au posts formed a metallic bond by room temperature bonding at wafer level in ambient without using external pressure after storage in air for a period of time, e.g. 60 hr depending on the metal thickness and bonding energy. When the wafer pairs were forcibly separated, by inserting a wedge between the bonded interface, either the Au or the Au/oxide layer peeled from the silicon substrate, indicating that the metal-to-metal bond formed was stronger than the adhesion of the Au pad on the oxide surface or the oxide on the silicon surface. As mentioned above, a strong metallic bond can be formed between the intimately contacted metal pads at room temperature due to inter-diffusion or self-diffusion of metal atoms on the mating interface to reduce the surface free energy. The inter-diffusion or self-diffusion coefficient between metal atoms increases exponentially with temperature, in order to shorten the storage time to achieve full metallic bonding, annealing can be performed after room temperature bonding. The preferred annealing time for metallic bonding between the Au posts shortened as the temperature increased. For this case, 5 hr was preferred for 100° C, 1 hr for 150° C, and 5 min for 250° C. Thinner metals require lower temperatures for bonding than thicker metals due to higher pressure generated by the bonding of non-metal surrounding areas. The time for the formation of metallic bond at room temperature and at elevated temperatures becomes longer as the Au thickness (i.e., height) increases. For example, when the thickness of Au pads h is 600 Å, 5 min at 250°C is needed to form metallic bond while at h=500 Å, 15 min is required.

In flip-chip bonding of state-of-the art integrated circuits, the solder ball pitch is about 1000 μm. Therefore, an unbonded area width around the bonded metal posts that is comparable or less than 1000 um is sufficiently small for practical applications. Unbonded area widths substantially less than this amount can be obtained by this method. For example, experimental results show that when h = 200 Å, W is 20 μm, and when h = 300 Å, W is 30 μm. Because h is the height the metal extended above the die surface, h can be much smaller than actual metal thickness since metal can be partially buried in oxide or other insulator, h less than 200 Å can be readily achieved. In this case the unbonded ring width around the metal pads can be close to zero. The metal pad described above may be formed by processes such as, but not limited to, sputtering, evaporation, laser ablation, chemical vapor deposition, and other techniques know to those skilled in the art in which thickness control in the < 100 Angstrom range is typical.

FIGS. 3A-3C are schematic drawings of a process according to a second embodiment of the present invention, by which two different fully processed dies are bonded. The dies are shown to have planar but uneven layer thickness, to demonstrate that the invention may be used in other instances other than even and planar layer thicknesses. In this process, as shown in FIG. 3A, a separate die 30 (only the oxide layer of die 30 is shown, for convenience of explanation) has metal pads 31. The die may be a silicon wafer including semiconductor devices and circuits have opposing surfaces of $SiO_2$. Surface 32 results after a CMP operation.

As shown in FIG. 3B, vias 36 have been formed and filled with metal to connect with metal pads 31, metal interconnects 33 are formed on wafer 30 to connect with the metal in vias 36, and a layer 34 of thickness $t_2$, of $SiO_2$ or other insulating material is formed on wafer 30. Portions 35 of the $SiO_2$ layer having a width $w_2$ have been removed to expose metal pads 35. The surface of layer 34 is treated as described in copending applications 09/410,054, 09/505,283 and 09/532,886, including polishing or polishing and slightly etching.

In FIG. 3C, a second wafer 37 has pads 38, vias 39 filled with metal, and interconnects 40 formed as shown. Interconnects 40 have a width $w_1$ and a height $t_1$. Surface 41 of wafer 37 has been treated like surface 32, as discussed above. The separate dies 30 and 37 are aligned and contacted one to another to produce the bonded structure shown in FIG. 3D. With the following relationships:

$$t_1 = t_2 + \delta_1 \text{ and } w_1 = w_2 + \delta_2,$$

where $t_1$ and $\delta_1$ are preferred to be the minimum thickness possible for the deposition technology used, and $\delta_2$ should be 2W corresponding to the case of $2h=t_1$. Compared with $h= t_1$ on both dies to be bonded, unbonded area width W is significantly reduced. Thus interconnection between the pads on wafers 30 and 37 is made. If $t_1$ on both dies is less than the critical thickness $h_{crit}$ then no layer 34 is required.

During the initial contacting of the two wafers at room temperature, the metal pads are aligned, and the surfaces of the wafers, according to the present invention, conform to each other by elastic deformation, provided the gap due to the surface topography of bonding wafers is sufficiently small and the bonding energy y is sufficiently high. According to the present invention, direct bonding occurs between the contacted materials forming the metal interconnects between devices or circuits on adjoining dies and between the wafer surfaces. The bond begins to form on contact and the bond strength increases, at room temperature, to form a metallic bond.

As in the first embodiment, wafer surfaces 32 and 41 including metal pads 33 and 40 contact, the contacting non-metal parts of opposing wafer surfaces 32 and 41 began to form a bond at the contact points, and the bonding force increases as the contact bonding area increases. Without the presence of metal pads 33 and 40, the wafers would bond across the entire wafer surface. According to the present invention, the presence of metal pads 33 and 40, while interrupting the bonding seam between the opposing wafers, does not prohibit wafer to wafer bonding. Rather, the pressure generated by the wafer-to-wafer contact in the non-metal regions translates into a force by which metal pads 33 and 40 are contacted. No external pressure is required.

The method of the present invention can be carried out in ambient conditions rather than being restricted to high or ultra-high vacuum (UHV) conditions. Consequently, the method of the present invention is a low-cost, mass-production manufacturing technology. The size of metal films to be bonded is, according to the present invention, flexible and scalable to very small geometries because direct metallic bonding depends only on intermolecular attraction force.

Direct metal bonding is preferable for better thermal management and power capability of semiconductor devices. The direct metal bonding, according to the present invention, can replace flip-chip bonding with much smaller bonding pads that are scalable. It is further possible that this metal bonding can be used to realize novel metal base devices (semiconductor-metal-semiconductor devices) See for example, T. Shimatsu, R.H. Mollema, D. Monsma, E.G. Keim and J.C. Lodder, IEEE Tran. Magnet. 33, 3495 (1997).

Further, the process is compatible with VLSI technology. The direct metal-to-metal bonding may be performed when wafers are fully processed. The direct metal-to-metal bonding of the present invention also utilizes room temperature bonding to minimize effects from the difference in thermal expansion, since almost all metals have significantly higher thermal expansion coefficients than silicon or silicon dioxide.

The present invention can bond locally or across an entire wafer surface area. The present invention, while not limited to the following examples, bonds heterogeneous surfaces such that metal/metal, oxide/oxide, semiconductor/semiconductor, semiconductor/oxide, and/or metal/oxide regions can be bonded between two wafers at room temperature.

Numerous advantages are offered by the present invention. For example, other methods of wafer bonding and electrically interconnected constituent electrical contacts require thinning of bonded substrates, via etching and metal deposition after wafer bonding. The present invention eliminates the need for these post-bond process steps to form electrical interconnections. Advantages of this elimination include the elimination of mechanical damage caused by the die thinning. Furthermore, the elimination of deep via etching avoids step coverage problems and allows the electrical connection to be scaled to smaller dimensions, resulting in an electrical interconnection with a smaller footprint and reduced electrical parasitics between bonded wafers. The method is compatible with other standard semiconductor processes, and is VLSI compatible.

As such, the present invention is compatible with 3-D SOC (three-dimensional system-on-a chip) fabrication. This vertical metal bonding of metal pads or interconnects using plugs between bonded dies significantly simplifies the SOC fabrication process and improves the SOC speed-power performance. The direct metal-to-metal bonding of the present invention is scalable and can be applied to multi-die stacking SOC.

Besides generation of the requisite force necessary to form metal-to-metal connections, the present invention recognizes that low resistance is desirable for the electrical interconnections from one device to another. Low resistance metal bonding is facilitated, according to the present invention, by oxide-free or nearly oxide-free surfaces of the metal bonding metal pads. For example, Au surface can be cleaned by ultraviolet/ozone and nitrogen plasma with no oxide left on the surfaces.

In another embodiment of the present invention, the surfaces of the bonding metal pads (fabricated for example from metals such as Al or Cu are coated with oxidation resistant metals, such as for example with gold (Au) or platinum (Pt) layer. Since both Au and Pt are inert metals, no oxide will be formed on the surfaces. To ensure that there is a minimum amount of oxide between Au or Pt and the host metal, sputter cleaning and evaporation deposition are employed, preferably immediately prior to the bonding process.

In a modification of the first embodiment of the present invention, a thin metal overcoat layer may be formed on the metal pad and bonded as described above. For example, a layer as thin as 50 Å of an Au layer on an Al pad produced successful metal pad bonding at room temperature. Therefore, metals such as Au can be used as a bonding layer, enabling almost all metals to be utilized for direct bonding at room temperature by the procedures of the present invention. When an insulator layer is deposed on a fully processed wafer and contact openings are formed on the metal pads followed by a metal deposition with thickness 100 Å more than the depth of the contact windows, the metal pads now are extended above oxide layer only 100 Å, the pads can be separated each other by a very small distance, e.g. 20 $\mu$m.

Besides Au or Pt, palladium (Pd) has been utilized in the present invention as an overcoat layer. Pd has good oxidation resistance. The surface diffusivity of Pd on Pd is very high resulting in a significant mass transport of Pd even at room temperature, especially given the contacting pressures exerted on the metal bonding pads by the bonding of the non-metal wafer surface regions. The native oxide between the two Pd bonding layers, if any, will be mechanically dispersed allowing complete coverage with Pd of the physical interface between the two contacted metal bonding pads.

In another modification of the first embodiment of the present invention, a UV/ozone cleaning exposes the surfaces of the metal bonding pads to high ozone concentrations under a UV light to remove hydrocarbon contamination. Residual hydrocarbons on the surfaces of the metal bonding pads degrade metal bonding, and are nucleation sites for bubble formation between the bonding interfaces, resulting in out-gassing between the contacted surfaces.

Experiments have shown that UV/ozone treatments can prevent interface bubble formation. An HF dip of silicon wafers leads to hydrophobic surfaces that are terminated mostly by H. The hydrophobic silicon wafers are treated with 4.77 g/m$^3$ of ozone concentration combined with 1850 Å and 2540 Å UV irradiation from two 235 W UV lamps at room temperature for 15 min. followed by a second HF dip and bonding. The bonded pairs of HF dipped hydrophobic silicon wafers generated no interface bubbles upon annealing from 300°C to 700°C for 15 hrs at each temperature clearly indicating the effective removal of hydrocarbons from the wafer surfaces.

For Au and Pt, it is adequate to use UV/ozone cleaning before bonding without formation of metal oxide on the metal surfaces. For other metals that can be oxidized by ozone, a thin layer of Au on the metals can prevent oxidation, or the oxide can be removed by e.g. immersion in $NH_4OH$ before bonding. In addition, plasma treatment with inert gases, for example plasma treatments in a reactive ion etch mode (RIE) with only inert gasses such as nitrogen and argon in the plasma chamber, can according to the present invention can clean metal surfaces and enhance the bonding energy at room temperature for both metal/metal and oxide/oxide bonds. Further, the present invention has discovered that an oxygen plasma can be used to remove contamination from the surface of metals such as Au and Pt.

While numerous surface preparation treatments and metal/metal and oxide/oxide and semiconductor/semiconductor examples have been described, other surfaces and preparation procedures could be used, according to the present invention, in which the corresponding metal, insulator, and semiconductor surfaces are sufficiently cleaned prior to contact such that the formation of room temperature bonding is not inhibited. In the case of Au protection or Au bonding, the process developed by the present invention is metal and silicon dioxide compatible. After CMP and surface planarization and smoothing of the oxide surfaces, metal bonding pads are formed on bonding wafers as described above, a modified RCA 1 ($H_2O$:$H_2O_2$:$NH_4OH$ =5:1:0.25), UV/ozone, and plasma treatment clean the surfaces of both metal and oxide without roughening the bonding surfaces. A room temperature standard 29% $NH_4OH$ dip removes particles and oxide on the metal surfaces if any without degrading the silicon dioxide surfaces. After spin-drying and room temperature bonding and storage, strong covalent bond and metallic bond are formed spontaneously at bonding inter face between oxide layers and metal surfaces, respectively. Besides the near planar bonding structures shown in FIGS. 1A-1D, other structures can also utilize the principles of the present invention. For example, a second embodiment is shown in FIGS. 4A-4C, where wafers including metal via interconnections are bonded to a smaller die. FIG. 4A depicts a magnified view of a substrate 50 including metal interconnects 51. In FIG. 4A, the metal interconnects are embedded in a silicon dioxide layer 52 such as a PECVD oxide, thermal oxide, or spin-on glass. Interconnects 51 extend above the layer 52 to a height as discussed previously. FIG. 4A also shows smaller die 53 having metal contact 54 and silicon dioxide layer 55.

Following forming an insulating layer 58 on both dies of a material such as silicon dioxide, a standard via etch and metal fill, followed by chemical mechanical polish and surface treatment are used to prepare the layers 58 for bonding. FIG. 4B depicts a pair of opposing wafers with reciprocal metal bonding pads 56 and 57. FIG. 4C shows the contacting and subsequent bonding of these two opposing substrates, forming bond 59.

Here, as before, the bonding of the non-metal regions generates the requisite forces to form the metal-to-metal interconnections across the dies. As depicted in FIG: 4C, the bonding of the oxide layers generates the requisite bonding force for direct metal-to-metal contact of the metal bonding pads 56 and 57. A plurality of dies 53 may be prepared and bonded to die 60, as shown in FIG. 4D.

In the metal-to-metal direct bonding of the first and second embodiments of the present invention, the thickness of bonding metal films extended above die surface is preferably thin to minimize the unbonded ring area around the metal posts. Further, the thickness of bonding metal pads is scaleable, and VLSI compatible size metal posts or pads can be made and bonded. When the metal film thickness is below a certain value, the width of the unbonded ring area is significantly reduced so that the spacing between metal posts permits small spacing (e.g. <10 $\mu$m) between the metal bonding pads to be used.

A third embodiment of the invention allows a significant increase in the metal height above the non-metal surface and/or significant reduction in non-bonded area near the metal while maintaining an acceptable electrical connection between metal portions formed on separate wafers. In this embodiment, deformation of material in the vicinity of the metal material that forms the electrical contact is designed to result from the pressure at the metal surfaces from the wafer-to-wafer chemical bonding of the non-metal portions. This deformation may result in less pressure applied to the metal after the bonding process is complete, but adequate pressure to form an acceptable electrical connection between the metal portions. This deformation allows the gap near the metal surfaces to be significantly reduced or eliminated.

The object of the deformable material in the vicinity of the metal material forming the electrical contact is to allow the pressure generated by the chemical bonding of the non-metal surfaces to be sufficient to recess the metal material sufficiently into its respective surface so that the gap near the metal surface can be significantly reduced or eliminated. In general, the deformable material is comprised of non-metal portions because the pressure generated by the wafer-to-wafer chemical bonding is typically about one part in 10,000 or 1% of 1% of that required to deform typical metals. The recess of the metal into its respective surface allows the starting height of the metal surface above the non-metal surface to be substantially higher than after the recess. This significantly increases the tolerances of the metal surface required to prepare the wafers for bonding and subsequently the manufacturability of the embodiment. The deformation also substantially reduces or eliminates the non-bonded region around the metal allowing a substantial increase in the number of connections that can be made in a given area and increasing the bond strength of the bonded and interconnected parts.

The deformation is enabled by the inclusion of a non-metal region underneath the metal surface, as illustrated in FIG. 5A. A die with a substrate 55 has a metal pad 50 formed on a layer 51 that is to be bonded to a corresponding layer on another device. Region 53, filled with a deformable non-metal material such as a low K dielectric material, is formed in layer 52 by standard photolithography, etching and deposition techniques. Layer 52 and region 53 are formed on layer 54. Any number of layers may be formed on substrate 54. Also, region 53 may be much larger or layer 52 may be formed of the low K material, as shown in FIG. 5B.

Region 53 may also be a void containing a vacuum or compressible gas like air, or it may be a compressible non-gas solid material with a sufficiently low compressibility that the pressure generated by the bonding will deform the metal into the region. The void may be formed in a manner similar to that used to fabricate metallic air bridges common in compound semiconductor integrated circuit fabrication. One example of this fabrication is as follows: 1) etch a recess in a planar, non-metal surface, 2) fill the recess with a removable material like photoresist such that the removable material is in the recess, but not outside the recess. This may, for example, be done by conventional spin coating of photoresist, resulting in a thicker photoresist in the recess than outside the recess, followed by blanket (non patterned) etching of the photoresist of an amount sufficient to remove the material outside the recess but not sufficient to remove the material in the recess, 3) patterning a metal feature that transverses the recess but does not entirely cover the recess, leaving an exposed portion of the recess, and 4) removal of the removal material in the recess by accessing the exposed portion of the recess. An example of a compressible non-gas solid material is a low K dielectric used in semiconductor manufacturing. The depth of this region is typically comparable to or greater than the desired height of metal above the non-metal surface. Another die to which the die of FIG. 5A is to be bonded may also have a region such as region 53 in a corresponding position beneath a metal pad to be bonded to pad 50. This is illustrated in FIG. 5C, where it is noted that FIG. 5C is a schematic drawing and is not shown to scale. Here, pads 50 and 56 are bonded by the compressive force generated by bonding of layers 51 and 57. The upper die in FIG. 5C includes a substrate 61 with pad 56 formed over void or low K material region 59 in layer 58. Layer 58 is formed on layer 59. Again, the upper die may have many layers.

In this embodiment, when the wafers are bonded, the metal surfaces are contacted and deformation with respect to each other occurs during the chemical bonding process. The deformation relieves some of the pressure applied by the bonding process, but sufficient pressure remains to maintain the metal surfaces in contact and maintain an acceptable minimum contact resistance between the two metal surfaces on the two separate wafers. As the metal deforms into the region under the metal, the bonding surfaces are allowed to come into contact in a lateral annulus very close or immediately adjacent to the metal, resulting in a maximum bonding area between the non-metal surfaces. A minimum chemical non-bonded region of 1 - 10 microns, or less, adjacent to the metal contact, can thus be formed by the present invention.

The deformable region is designed to have a minimum width to maximize the number of possible electrical interconnections. The deformable region width primarily depends on the metal thickness and the metal height above the non-metal surface. These parameters are approximately determined by the following relations.

$$\text{Stress} = (2/3)*(\text{Young's Modulus of Metal})(1/1-\text{ Metal Poisson's Ratio})*(\text{metal height above surface/half width of region})^2$$

and

$$\text{Pressure} = \text{Stress}*4*\text{metal thickness}*\text{metal height above surface}/(\text{half width of region})^2$$

Where the pressure is that generated by the bonding process. A reference for these relations can be found in the "Handbook of Thin Film Technology", Maissel and Glang, 1983 Reissue, pp12-24.

For example, for a metal thickness of about 0.1 micron and a metal height above the region of about 0.1 micron above the surface and a region width of about 1 micron, the pressure generated during bonding is approximately sufficient to deform the metal into the region (assuming compressibility of the region can be neglected). Note that this 0.1 micron metal height would have resulted in an unbonded annulus or ring width around the metal of about 1 mm if the metal was not deformable. The manufacturability is thus increased substantially by requiring less control of the metal height above the non-metal surface. Furthermore, the non-bonded area is substantially decreased allowing a significant increase in the number of metal to metal contacts that can be made and resulting in an increase in the chemical bonding energy. If the compressibility of the region can not be neglected, than the thickness of the metal needs to be reduced accordingly and/or the metal height above the non-metal surface needs to be reduced accordingly and/or the width of the region needs to be increased accordingly. Note that the percentage amount the width of the region needs to be increased is less than the percentage amount the metal height above the non-metal surface, or the metal thickness, needs to be reduced.

A fourth embodiment of the invention further relaxes the mechanical design constraints in the vicinity of the metal contacts described in the first, second, and third embodiments by relying on a low temperature, post-bond reflow anneal to form reliable electrical interconnections between chemically bonded wafers. A description of this embodiment is provided with reference to Figures 6A-C and 7A-C.

Figure 6A shows substrates 60 and 61 with planar surfaces. Recesses 62 and 63 are formed in substrates 60 and 61, respectively, and metal pads 64 and 65 are formed in recessed 62 and 63 respectively. The planar surfaces are suitable for chemical bonding as described previously. The metal or combination of metals making up pads 64 and 65 can reflow at low temperatures. Examples of such a metal is indium that reflows at a melting temperature of 160 degrees C, and such a combination of metals is 96.5% tin and 3.5% silver that reflows at a eutectic melting temperature of 220 degrees C.

After the surfaces in Figure 6A are prepared for direct chemical bonding and the surfaces are placed together, a chemical bond is formed between the planar surfaces. Compared to embodiments 1 and 2, there is no gap near the metal contacts because the contacts are recessed, although a reliable electrical interconnection is not yet made.

After the chemical bond in Figure 6B has been formed, a void 66 is formed by partially metal-filled recesses from both wafers. This void does not impede the wafer surfaces from coming together and forming a chemical bond like the metal contacts do in the first and second embodiments. A maximum bond area is thus realized that maximizes the bond energy. After this high bond energy chemical bond has been formed, a low temperature reflow anneal reflows the metal in the recesses resulting in wetting of the metal from the opposing wafers together and resulting in an interconnected metal structure with high reliability. Portions 67 are formed by the reflow to connect pads 64 and 65. This reflow is assisted with a combination of capillary action for recesses with high aspect ratios and gravity as, for example, if the wafers are rotated during the anneal.

In a fifth embodiment, similar to the fourth embodiment, one of the surfaces in Figure 6A has the metal recesses replaced with metal plateaus, such that the height of the metal plateau above the planar surface on one wafers is less than the depth of the metal recess below the planar surface on the other wafers as shown in Figure 7A. Substrates 70 and 71 have respective metal pads 72 and 73. Pads 72 are formed in recesses 74. In this case, the metal surfaces do not, in general, touch after the planar surfaces forming a chemical bond are placed in contact as shown in Figure 7B. The surfaces of substrates 70 and 71 are prepared for direct chemical bonding and the surfaces are placed together as in the above example, and a chemical bond is formed between the planar surfaces (FIG. 7B). After reflow, the metal on the two different wafers is wetted together, forming portions 75, in a manner similar to Figure 6C, resulting in Figure 7C.

Hence, the present invention offers numerous advantages and distinctions from prior low temperature wafer bonding techniques. The metal to metal direct bonding of the present invention is spontaneous and requires no external forces at room temperature. The pressure applied on the metal posts that is required for metal-to-metal bonding is generated by bonding process itself, and not external forces. The metal-to-metal direct bonding of the present invention is performed under ambient conditions and the following are realized: wafer level or die size bonds, strong metallic Au-Au, Cu-Cu or metal-to-metal bonds formed at room temperature, and strong metallic bond of metals other than Au and Cu can be formed at room temperature by covering the metals with a ~50 Å Au layer. Thus, simultaneous bonding of metal/metal, oxide/oxide and metal/oxide can be achieved. The metal-to-metal direct bonding of the present invention is compatible with standard VLSI processing and therefore, is a manufacturable technology. The metal to metal direct bonding of the present invention is compatible with bonding of materials covered with silicon oxides, silicon, or silicon nitride.

Facilitating the metal-to-metal direct bonding of the present invention is the direct bonding of the non-metal regions proximate to the metal bonding pads. As previously discussed, it is the direct bonding in these regions that generates the resultant force on the opposing metal bonding pads. The direct bonding of the non-metallic regions, according to the present invention, covalently bonds in air silicon dioxide or other insulator covered wafers. Other materials can be utilized, for example, fluorinated oxide surface layers that may also be dipped in an ammonia solution prior to bonding. More generically, any material with an open structure surface that can be terminated by OH, NH or FH groups, and porous low k materials when brought into contact at room temperature can form a covalent bond.

According to the present invention, silicon dioxide formed by any method such as deposition, thermally or chemically oxidation, and spin-on glass, can be used in pure or doped states.

Applications of the present invention include but are not limited to vertical integration of processed integrated circuits for 3-D SOC, micro-pad packaging, low-cost and high-performance replacement of flip chip bonding, wafer scale packaging, thermal management and unique device structures such as metal base devices.

Numerous modifications and variations of the present invention are possible in light of the above teachings. It is therefore to be understood that within the scope of the appended claims, the invention may be practiced otherwise than as specifically described herein.

## Claims

**1.** A bonding method comprising:

preparing a first substrate (10; 30) having a first metallic pad (12; 31) and a first non-metallic bonding region proximate to said first metallic pad (12; 31);
preparing a second substrate (13; 37) having a second metallic pad (15; 38) and a second non-metallic bonding region proximate to said second metallic pad (15; 38);
bringing said first metallic pad (12; 31) into physical contact with said second metallic pad (15);
**characterised by** bringing said first non-metallic bonding region into physical contact with said second non-metallic bonding region and forming a chemical bond between said first non-metallic bonding region and said second non-metallic bonding region byelastically deforming at least one of said first and second substrates (10, 13; 30, 37) to generate at least one point of contact between said first and second substrates (10, 13; 30, 37) so that a bond at said point of contact is initiated and said bond between said first and second substrates (10, 13; 30, 37) expands across a substantial portion of said first and second non-metallic bonding regions,
wherein chemical bond is defined as a bond strength developed when surface bonds on the surface of one substrate react with the surface bonds on an surface of an opposing substrate to form direct bonds across the surface elements, such as a covalent bond.

2. A bonding method, according to claim 1, wherein:

a first plurality of metallic pads (12; 31) is prepared on said first substrate (10; 30);
a second plurality of metallic pads (15; 38) is prepared on said second substrate (13; 37);
at least one pad from said first plurality of metallic pads (12; 31) is directly contacted, without solder, with at least one pad from said second plurality of metallic pads (15; 38);
said first non-metallic bonding region is directly contacted to said second non-metallic bonding region; and
said first non-metallic bonding region is nonadhesively bonded to said second non-metallic bonding region.

3. A method as recited in claim 1 or 2, comprising:

polishing each of said first and second non-metallic bonding regions to a surface roughness less than 15 Å; and
etching each of said first and second non-metallic bonding regions after said polishing.

4. A method as recited in any one of claims 1 to 3, comprising:

polishing each of said first and second non-metallic bonding regions to a surface roughness no more than 5Å.

5. A method as recited in any one of claims 2 to 4, comprising:

forming at least one pad of said first plurality of metallic pads (12; 31) to have an upper surface extending above a surface of said first non-metallic bonding region on said first substrate (10; 30); and
forming at least one pad of said second plurality of metallic pads (15; 38) to have an upper surface extending above a surface of said non-metallic bonding region on said second substrate (13; 37).

6. A method as recited in claim 2, wherein said directly contacting said at least one pad step comprises bonding the first plurality of metallic pads (12; 31) to the second plurality of metallic pads (15; 38).

7. A method as recited in any one of the preceding claims, comprising:

depositing metallic pads on the first substrate (10; 30) after forming said first non-metallic bonding region on said first substrate (10; 30).

8. A method as recited in claim 7, wherein depositing comprises depositing at least one of Pt, Au, Pd, and alloys thereof.

9. A method as recited in any one of the preceding claims, further comprising:

removing contamination from surfaces of the first and second plurality of metallic pads (12, 15; 31, 38).

10. A method as recited in claim 9, wherein removing comprises:

exposing said metallic pads to an UV/ozone treatment.

11. A method as recited in any one of claims 2 to 10, comprising:

forming the first and second plurality of metallic pads having a thickness substantially smaller than a separation distance between adjacent ones of said metallic pads.

12. A method as recited in any one of claims 2 to 11, comprising:

forming said first and second plurality of metallic pads (12, 15; 31, 38) to a thickness less than 1000 A above a surface of said first and second non-metallic bonding regions, respectively.

13. A method as recited in any one of claims 2 to 12, wherein said step of directly contacting comprises forming an unbonded area around contacted ones of said metallic pads (12, 15; 31, 38).

14. A method as recited in any one of the preceding claims, wherein preparing a first substrate (10; 30) and preparing a second substrate (13; 37) comprises forming an oxide layer on at least one of the first substrate and the second substrate having a surface roughness no more than 5 Å, and forming said oxide layer comprises at least one of:

depositing the oxide layer by chemical vapor deposition;
depositing the oxide layer by sputtering;
depositing the oxide layer by a spin-on glass process;
forming the oxide layer by thermal annealing; and
depositing the oxide layer by plasma enhanced chemical vapor deposition.

**15.** A method as recited in claim 14, comprising:

polishing said oxide layer.

**16.** A method as recited in claim 15, comprising:

etching said oxide layer after said polishing.

**17.** A method as recited in claim 16, comprising:

exposing said oxide layer to an oxygen plasma.

**18.** A method as recited in any one of claims 2 to 17, comprising:

forming a first bonding layer on said first substrate (10; 30) to cover said first plurality of metallic pads (12; 31);
forming an opening in said first bonding layer over selected ones of said first plurality of metallic pads (12; 31);
forming a second bonding layer on said second substrate (13; 37);
forming said second plurality of metallic pads (15; 38) on said second bonding layer, said second plurality of metallic pads (15; 38) corresponding to openings in said first bonding layer; and
directly contacting said first and second bonding layers.

**19.** A method as recited in any one of claims 2 to 18, wherein forming said first plurality of metallic pads (12; 31) comprises:

forming one of an aluminum, copper and aluminum alloy layer; and
forming one of an Au, Pd and Pt layer on said layer.

**20.** A method as recited in any one of the preceding claims, comprising:

exposing said first and second substrates (10, 13; 30, 37) to an oxygen plasma; and
removing an oxide layer from said metallic pads (12, 15; 31, 38).

**21.** A method as recited in any one of claims 2 to 20, wherein:

preparing said first substrate (10; 30) comprises forming a plurality of third substrates, each smaller than said second substrate (13; 37) and each having at least one third metallic pad;
contacting said at least one pad comprises contacting a third metallic pad of each of said third substrates with one of said second plurality of metallic pads (15; 38);
directly contacting comprises contacting a third non-metallic bonding region of each of said third substrates with said second non-metallic bonding region of said second substrate; and
said bonding comprises bonding said third non-metallic bonding regions to said second non-metallic bonding region.

**22.** A method as recited in claim 2, 3, 4, 5, 6, or 8, wherein each of preparing said first substrate (10; 30) and preparing said second substrate (13; 37) comprises:

forming a silicon dioxide layer;
patterning said silicon dioxide layer;
forming via holes in said silicon dioxide layer; and
forming a metal structure in said via holes.

**23.** A method as recited in any one of claims 2 to 22, comprising:

forming a first oxide layer on said first substrate (10; 30);
forming said first plurality of metallic pads (12; 31) extending above a surface of said first oxide layer;
forming a second oxide layer on said second substrate (13; 37); and
forming said second plurality of metallic pads (15; 38) recessed below a surface of said second oxide layer.

**24.** A method as recited in any one of claims 1 to 23, comprising:

forming a void or disposing a deformable material beneath at least one of said first plurality of metallic pads (12, 15; 31, 38).

**25.** A method as recited in claim 24 comprising:

deforming a material beneath said at least one pad to extend into said void.

**26.** A method as recited in any one of claims 2 to 24, comprising:

reducing an unbonded area around at least one of said first and second plurality of metallic pads (12, 15; 31, 38) using a void disposed proximate to or disposing a deformable material beneath said at least one of said first and second plurality of metallic pads (12, 15; 31, 38).

**27.** A method as recited in claim 26, comprising:

reducing a thickness of said material in an area beneath said at least one of said first plurality of metallic pads (12, 31).

**28.** A method as recited in claim 25, comprising:

disposing a deformable low K material beneath said at least one of said first plurality of metallic pads (12, 31).

**29.** A method as recited in claim 28, wherein:

reducing a thickness of said low K material in an area beneath said at least one of said first plurality of metallic pads.

**30.** A method as recited In any one of the preceding claims, comprising:

forming a chemical bond between said first non-metallic bonding region and said second non-metallic bonding region at about room temperature.

**31.** A method as recited in any one of the preceding claims, comprising:

forming said chemical bond between said first non-metallic bonding region and said second non-metallic bonding region without applying external pressure during bonding.

**32.** A method as recited in any one of the preceding claims, comprising:

forming at least one of said first and second plurality of metallic pads (12, 31; 31, 38) to have a upper surface substantially coplanar with an upper surface of first and second non-metallic bonding regions, respectively.

**33.** A method as recited in any one of claims 2 to 32, comprising:

forming said first plurality of metallic pads (12, 31) in said first non-metallic bonding region; and
chemical-mechanically polishing said first plurality of metallic pads and said first non-metallic bonding region.

**34.** A method as recited in any one of claims 2 to 33, comprising:

heating said at least one pad from said first plurality of metallic pads (12, 31) and said at least one pad from said second plurality of metallic pads (15, 38) after said step of directly contacting said first non-metallic bonding region to said second non-metallic bonding region.

**35.** A method as recited in any one of the preceding claims, wherein:

preparing said first substrate (10; 30) comprises preparing a die having a substrate portion.

**36.** A method as recited in claim 21, wherein:

forming said plurality of third substrates comprises forming a plurality of die each having a substrate portion.

**37.** A method as recited in claim 1, comprising:

preparing a plurality of first substrates (10; 30) each having a first metallic pad (12, 31) and a first non-metallic bonding region proximate to said first metallic pad;
preparing said second substrate (13; 37) having a plurality of second metallic pads (35, 38) and a second non-metallic bonding region proximate to each of said second metallic pads (35, 38);
bringing said first metallic pad (12, 31) of each of said plurality of first substrates (10; 30) into physical contact with one of said second metallic pads (35, 38);
bringing each of said first non-metallic bonding regions into physical contact with one of said second non-metallic bonding regions; and
forming a chemical bond between said first non-metallic bonding regions and said second non-metallic bonding regions.

**38.** A method as recited in claim 37, wherein:

preparing said plurality of first substrates comprises forming a plurality of die each having a substrate portion.

**39.** A method as recited in claim 25, comprising:

deforming the material beneath said at least one pad.

**40.** A method as recited claim 2, comprising:

heating said at least one pad from said first plurality of metallic pads (12, 31) and said at least one pad from said second plurality of metallic pads (15, 38) after said step of directly contacting said first non-metallic bonding region to said second non-metallic bonding region to form a connection between said at least one pads from said first and second plurality of metallic pads.

**41.** A method as recited in claim 2, comprising:

generating pressure between the at least one pad from said first plurality of metallic pads (12; 31) and the at least one pad from said second plurality of metallic pads (15; 38) from bonding the first and second non-metallic bonding regions.

**42.** A method as recited in claim 2, 3, 4, 5, 6, or 8, wherein each of preparing said first substrate (10; 30) and preparing said second substrate (13; 37) comprises:

forming a silicon nitride layer;
patterning said silicon nitride layer;
forming via holes in said silicon nitride layer; and
forming a metal structure in said via holes.

**Patentansprüche**

**1.** Verbindungsverfahren umfassend:

Herstellen eines ersten Substrats (10; 30), welches ein erstes metallisches Pad (12; 31) und einen ersten nicht-metallischen Bindungsbereich benachbart zu dem ersten metallischen Pad (12; 31) aufweist;
Herstellen eines zweiten Substrats (13; 37), welches ein zweites metallisches Pad (15; 38) und einen zweiten nicht-metallischen Bindungsbereich benachbart zu dem zweiten metallischen Pad (15; 38) aufweist;
in körperlichen Kontakt Bringen des ersten metallischen Pads (12; 31) mit dem zweiten metallischen Pad (15);
**gekennzeichnet durch**
in körperlichen Kontakt Bringen des ersten nicht-metallischen Bindungsbereichs mit dem zweiten nicht-metallischen Bindungsbereich und Bilden einer chemischen Bindung zwischen dem ersten nicht-metallischen Bindungsbereich und dem zweiten nicht-metallischen Bindungsbereich **durch** elastisches Verformen zumindest eines des ersten oder des zweiten Substrats (10, 13; 30, 37), um zumindest eine Kontaktstelle zwischen dem ersten und dem zweiten Substrat (10, 13; 30, 37) zu erzeugen, so dass eine Verbindung bei der Kontaktstelle angeregt wird und sich die Verbindung zwischen dem ersten und dem zweiten Substrat (10, 13; 30, 37) über einen wesentlichen Teil des ersten und zweiten nicht-metallischen Bindungsbereichs ausdehnt,
wobei die chemische Bindung als Bindungsstärke definiert ist, die sich entwickelt, wenn Oberflächenbindungen auf der Oberfläche eines Substrats mit den Oberflächenbindungen auf einer Oberfläche eines gegenüberliegenden Substrats reagieren, um direkte Bindungen über die Flächenelemente zu bilden, wie beispielsweise eine kovalente Bindung.

**2.** Verbindungsverfahren nach Anspruch 1, wobei:

eine erste Vielzahl metallischer Pads (12; 31) auf dem ersten Substrat (10; 30) hergestellt wird;
eine zweite Vielzahl metallischer Pads (15; 38) auf dem zweiten Substrat (13; 37) hergestellt wird;
zumindest ein Pad der ersten Vielzahl metallischer Pads (12; 31) direkt, ohne zu löten, mit zumindest einem Pad der zweiten Vielzahl metallischer Pads (15; 38) in Kontakt gebracht wird;
der erste nicht-metallische Bindungsbereich direkt mit dem zweiten nicht-metallischen Bindungsbereich in Kontakt gebracht wird; und
der erste nicht-metallische Bindungsbereich nicht-adhesiv mit dem zweiten nicht-metallischen Bereich gebunden wird.

**3.** Verfahren nach Anspruch 1 oder 2, umfassend:

Polieren des ersten und zweiten nicht-metallischen Bindungsbereichs auf eine geringere Oberflächenrauigkeit als 15 Å; und
Ätzen des ersten und zweiten nicht-metallischen Bindungsbereichs nach dem Polieren.

**4.** Verfahren nach einem der Ansprüche 1 bis 3, umfassend:

Polieren des ersten und zweiten nicht-metallischen Bindungsbereichs auf eine geringere Oberflächenrauigkeit als 5Å.

**5.** Verfahren nach einem der Ansprüche 2 bis 4, umfassend:

Bilden zumindest eines Pads der ersten Vielzahl metallischer Pads (12; 31) derart, dass sich die obere Fläche über eine Fläche des ersten nicht-metallischen Bindungsbereichs auf dem ersten Substrat (10; 30) erstreckt; und
Bilden zumindest eines Pads der zweiten Vielzahl metallischer Pads (15; 38) derart, dass sich die obere Fläche über eine Fläche des nicht-metallischen Bindungsbereichs auf dem zweiten Substrat (13; 37) erstreckt.

**6.** Verfahren nach Anspruch 2, wobei der Schritt des direkten in Kontakt Bringens des zumindest einen Pads das Binden der ersten Vielzahl metallischer Pads (12; 31) mit der zweiten Vielzahl metallischer Pads (15; 38) umfasst.

**7.** Verfahren nach einem der vorhergehenden Ansprüche, umfassend:

Abscheiden metallischer Pads auf dem ersten Substrat (10; 30) nach dem Bilden des ersten nicht-metallischen Bindungsbereichs auf dem ersten Substrat (10; 30).

**8.** Verfahren nach Anspruch 7, wobei das Abscheiden ein Abscheiden von zumindest eines von Pt, Au, Pd und Legierungen davon umfasst.

**9.** Verfahren nach einem der vorhergehenden Ansprüche, ferner umfassend:

Entfernen von Verunreinigungen von den Oberflächen der ersten und zweiten Vielzahl metallischer Pads (12, 15; 31, 38).

**10.** Verfahren nach Anspruch 9, wobei das Entfernen umfasst:

die metallischen Pads einer UV/Ozon-Behandlung auszusetzen.

**11.** Verfahren nach einem der Ansprüche 2 bis 10, umfassend:

Bilden der ersten und zweiten Vielzahl metallischer Pads derart, dass sie eine Dicke aufweisen, die wesentlich geringer ist als ein Trennungsabstand zwischen benachbarten metallischen Pads.

**12.** Verfahren nach einem der Ansprüche 2 bis 11, umfassend:

Bilden der ersten und zweiten Vielzahl metallischer Pads (12, 15; 31, 38) derart, dass sie eine Dicke geringer als 1000 Å über einer Fläche des ersten bzw. des zweiten nicht-metallischen Bindungsbereichs aufweisen.

**13.** Verfahren nach einem der Ansprüche 2 bis 12, wobei der Schritt des direkten in Kontakt Bringens das Bilden eines nicht gebundenen Bereichs um in Kontakt gebrachte metallische Pads (12, 15; 31, 38) herum umfasst.

**14.** Verfahren nach einem der vorhergehenden Ansprüche, wobei das Herstellen eines ersten Substrats (10; 30) und das Herstellen eines zweiten Substrats (13; 37) das Bilden einer Oxidschicht auf zumindest einem des ersten Substrats und des zweiten Substrats mit einer Oberflächenrauigkeit nicht mehr als 5 Å umfasst, und das Bilden der Oxidschicht zumindest einen der folgenden Schritte umfasst:

Abscheiden der Oxidschicht durch chemische Dampfphasenabscheidung;
Abscheiden der Oxidschicht durch Zerstäuben;
Abscheiden der Oxidschicht durch einen Auf-Glas-Schleuderprozess;
Bilden der Oxidschicht durch thermisches Ausglühen; und
Abscheiden der Oxidschicht durch Plasma-verstärkte chemische Dampfphasenabscheidung.

**15.** Verfahren nach Anspruch 14, umfassend:

Polieren der Oxidschicht.

**16.** Verfahren nach Anspruch 15, umfassend:

Ätzen der Oxidschicht nach dem Polieren.

**17.** Verfahren nach Anspruch 16, umfassend:

die Oxidschicht einem Sauerstoffplasma aussetzen.

**18.** Verfahren nach einem der Ansprüche 2 bis 17, umfassend:

Bilden einer ersten Bindungsschicht auf dem ersten Substrat (10; 30), um die erste Vielzahl metallischer Pads (12; 31) abzudecken;
Bilden einer Öffnung in der ersten Bindungsschicht über ausgewählten metallischen Pads der ersten Vielzahl metallischer Pads (12; 31);
Bilden einer zweiten Bindungsschicht auf dem zweiten Substrat (13; 37);
Bilden der zweiten Vielzahl metallischer Pads (15; 38) auf der zweiten Bindungsschicht, wobei sich die zweite Vielzahl metallischer Pads (15; 38) mit den Öffnungen in der ersten Bindungsschicht decken; und
direktes in Kontakt Bringen der ersten und zweiten Bindungsschichten.

**19.** Verfahren nach einem der Ansprüche 2 bis 18, wobei das Bilden der ersten Vielzahl metallischer Pads (12; 31) umfasst:

Bilden einer Aluminiums-, Kupfer- oder Aluminiumlegierungsschicht; und
Bilden einer Au-, Pd- oder Pt-Schicht auf der Schicht.

**20.** Verfahren nach einem der vorhergehenden Ansprüche, umfassend:

das erste und zweite Substrat (10, 13; 30, 37) einem Sauerstoffplasma auszusetzen, und
eine Oxidschicht von den metallischen Pads (12, 15; 31, 38) zu entfernen.

**21.** Verfahren nach einem der Ansprüche 2 bis 20, wobei:

das Herstellen des ersten Substrats (10; 30) das Bilden einer Vielzahl dritter Substrate umfasst, von denen jedes kleiner als das zweite Substrat (13; 37) ist und jedes zumindest ein drittes metallisches Pad aufweist;
das in Kontakt Bringen des zumindest einen Pads ein in Kontakt Bringen eines dritten metallischen Pads eines jeden dritten Substrats mit einem der zweiten Vielzahl metallischer Pads (15; 38) umfasst;
das direkte in Kontakt Bringen ein in Kontakt Bringen eines dritten nicht-metallischen Bindungsbereichs jedes dritten Substrats mit dem zweiten nicht-metallischen Bindungsbereich des zweiten Substrats umfasst; und
das Binden ein Binden des dritten nicht-metallischen Bindungsbereichs mit dem zweiten nicht-metallischen Bindungsbereich umfasst.

**22.** Verfahren nach einem der Ansprüche 2, 3, 4, 5, 6 oder 8, wobei jedes Herstellen des ersten Substrats (10; 30) und Herstellen des zweiten Substrats (13; 37) umfasst:

Bilden einer Siliziumdioxidschicht;
Strukturieren der Siliziumdioxidschicht;
Bilden von Bohrungen in der Siliziumdioxidschicht; und
Bilden einer Metallstruktur in den Bohrungen.

**23.** Verfahren nach einem der Ansprüche 2 bis 22, umfassend:

Bilden einer ersten Oxidschicht auf dem ersten Substrat (10; 30);
Bilden der ersten Vielzahl metallischer Pads (12; 31) derart, dass sie sich über einer Oberfläche der ersten Oxidschicht erstreckt;
Bilden einer zweiten Oxidschicht auf dem zweiten Substrat (13; 37); und
Bilden der zweiten Vielzahl metallischer Pads (15; 38), welche gegenüber einer Oberfläche der zweiten Oxidschicht nach unten zurückversetzt sind.

**24.** Verfahren nach einem der Ansprüche 1 bis 23, umfassend:

Bilden einer Lücke oder Einbringen eines verformbaren Materials unterhalb zumindest eines Pads der ersten Vielzahl metallischer Pads (12, 15; 31, 38).

**25.** Verfahren nach Anspruch 24, umfassend:

Verformen eines Materials unterhalb des zumindest einen Pads, so dass es sich in die Lücke erstreckt.

**26.** Verfahren nach einem der Ansprüche 2 bis 24, umfassend:

Absenken eines nicht gebundenen Bereichs um zumindest ein metallisches Pad der ersten und zweiten Vielzahl metallischer Pads (12, 15; 31, 38) herum durch Verwendung einer Lücke, die benachbart zu dem zumindest einen metallischen Pad der einen und zweiten Vielzahl metallischer Pads (12, 15; 31, 38) angeordnet ist, oder durch Einbringen eines verformbaren Materials unterhalb des zumindest einen metallischen Pads der ersten und zweiten Vielzahl metallischer Pads (12, 15; 31, 38).

**27.** Verfahren nach Anspruch 26, umfassend:

Verringern einer Dicke des Materials in einem Bereich unterhalb des zumindest einen Pads der ersten Vielzahl metallischer Pads (12, 31).

**28.** Verfahren nach Anspruch 25, umfassend:

Einbringen eines verformbaren Low-k-Materials unterhalb des zumindest einen Pads der ersten Vielzahl metallischer Pads (12, 31).

**29.** Verfahren nach Anspruch 28, wobei:

eine Dicke des Low-k-Materials in einem Bereich unterhalb des zumindest einen metallischer Pads der ersten Vielzahl metallischer Pads verringert wird.

**30.** Verfahren nach einem der vorhergehenden Ansprüche, umfassend:

Bilden einer chemischen Bindung zwischen dem ersten nicht-metallischen Bindungsbereich und dem zweiten nicht-metallischen Bindungsbereich bei etwa Raumtemperatur.

**31.** Verfahren nach einem der vorhergehenden Ansprüche, umfassend:

Bilden der chemischen Bindung zwischen dem ersten nicht-metallischen Bindungsbereich und dem zweiten nicht-metallischen Bindungsbereich ohne Ausübung eines äußeren Drucks während des Bindens.

**32.** Verfahren nach einem der vorhergehenden Ansprüche, umfassend:

Bilden des zumindest einen Pads der ersten und zweiten Vielzahl metallischer Pads (12, 31; 31; 38) derart, dass es eine obere Fläche aufweist, die im Wesentlichen koplanar mit einer oberen Fläche des ersten bzw. zweiten nicht-metallischen Bindungsbereichs ist.

**33.** Verfahren nach einem der Ansprüche 2 bis 32, umfassend:

Bilden einer ersten Vielzahl metallischer Pads (12, 31) in dem ersten nicht-metallischen Bereich; und
chemisch-mechanisches Polieren der ersten Vielzahl metallischer Pads und des ersten nicht-metallischen Bindungsbereichs.

**34.** Verfahren nach einem der Ansprüche 2 bis 33, umfassend:

Erhitzen des zumindest einen Pads der ersten Vielzahl metallischer Pads (12, 31) und des zumindest einen Pads der zweiten Vielzahl metallischer Pads (15, 38) nach dem Schritt des direkten in Kontakt Bringens des ersten nicht-metallischen Bindungsbereichs mit dem zweiten nicht-metallischen Bindungsbereich.

**35.** Verfahren nach einem der vorhergehenden Ansprüche, wobei:

das Herstellen des ersten Substrats (10; 30) ein Herstellen eines Chips mit einem Substratanteil umfasst.

**36.** Verfahren nach Anspruch 21, wobei:

das Bilden der Vielzahl dritter Substrate ein Bilden einer Vielzahl von Chips umfasst, wobei jeder Chip einen Substratanteil aufweist.

**37.** Verfahren nach Anspruch 1, umfassend:

Herstellen einer Vielzahl erster Substrate (10; 30), wobei jedes ein erstes metallisches Pad (12, 31) und einen ersten nicht-metallischen Bindungsbereich benachbart zu dem ersten metallischen Pad aufweist;
Herstellen des zweiten Substrats (13; 37), das eine Vielzahl zweiter metallischer Pads (35, 38) aufweist, und eines zweiten nicht-metallischen Bindungsbereichs benachbart zu jedem Pad der zweiten metallischen Pads (35, 38);
in körperlichen Kontakt Bringen des ersten metallischen Pads (21; 31) eines jeden Substrats der Vielzahl der ersten Substrate (10; 30) mit einem der zweiten metallischen Pads (35; 38);
in körperlichen Kontakt Bringen des ersten nicht-metallischen Bindungsbereichs mit einem der zweiten nicht-metallischen Bindungsbereiche;

Bilden einer chemischen Bindung zwischen den ersten nicht-metallischen Bindungsbereichen und den zweiten nicht-metallischen Bindungsbereichen.

**38.** Verfahren nach Anspruch 37, wobei:

das Herstellen der Vielzahl erster Substrate ein Formen einer Vielzahl von Chips mit jeweils einem Substratanteil umfasst.

**39.** Verfahren nach Anspruch 25, umfassend:

Verformen des Materials unterhalb des zumindest einen Pads.

**40.** Verfahren nach Anspruch 2, umfassend:

Erhitzen des zumindest einen Pads der ersten Vielzahl metallischer Pads (12, 31) und des zumindest einen Pads der zweiten Vielzahl metallischer Pads (15, 38) nach dem Schritt des direkten in Kontakt Bringens des ersten nicht-metallischen Bindungsbereichs mit dem zweiten nicht-metallischen Bindungsbereich zum Bilden einer Verbindung zwischen dem zumindest einen Pad der ersten und zweiten Vielzahl metallischer Pads.

**41.** Verfahren nach Anspruch 2, umfassend:

Erzeugen von Druck zwischen dem zumindest einen Pad der ersten Vielzahl metallischer Pads (12; 31) und dem zumindest einen Pad der zweiten Vielzahl metallischer Pads (15; 38) aus dem Binden des ersten und des zweiten nicht-metallischen Bindungsbereichs.

**42.** Verfahren nach einem der Ansprüche 2, 3, 4, 5, 6 oder 8, wobei jede Herstellung des ersten Substrats (10; 30) und Herstellung des zweiten Substrats (13; 37) umfasst:

Bilden eine Siliziumnitridschicht;
Strukturieren der Siliziumnitridschicht;
Bilden von Bohrungen in der Siliziumnitridschicht; und
Bilden einer Metallstruktur in den Bohrungen.

## Revendications

**1.** Procédé de liaison, comprenant les étapes consistant à :

préparer un premier substrat (10 ; 30) ayant un premier plot métallique (12 ; 31) et une première région de liaison non métallique proche dudit premier plot métallique (12 ; 31) ;
préparer un deuxième substrat (13 ; 37) ayant un deuxième plot métallique (15 ; 38) et une deuxième région de liaison non métallique proche dudit deuxième plot métallique (15 ; 38) ;
amener ledit premier plot métallique (12 ; 31) en contact physique avec ledit deuxième plot métallique (15) ;
**caractérisé en ce que** l'on amène ladite première région de liaison non métallique en contact physique avec ladite deuxième région de liaison non métallique et l'on forme une liaison chimique entre ladite première région de liaison non métallique et ladite deuxième région de liaison non métallique en déformant de manière élastique au moins l'un desdits premier et deuxième substrats (10, 13 ; 30, 37) pour générer au moins un point de contact entre lesdits premier et deuxième substrats (10, 13 ; 30, 37) de sorte qu'une liaison audit point de contact soit initiée et que ladite liaison entre les premier et deuxième substrats (10, 13 ; 30, 37) se dilate en travers d'une portion sensible desdites première et deuxième régions de liaison non métalliques,
dans lequel la liaison chimique est définie par une force de liaison développée lorsque les liaisons de surface sur la surface d'un substrat réagissent avec les liaisons de surface sur une surface d'un substrat opposé pour former des liaisons directes en travers d'éléments de surface, notamment une liaison covalente.

**2.** Procédé de liaison selon la revendication 1, dans lequel :

une première pluralité de plots métalliques (12 ; 31) sont préparés sur ledit premier substrat (10 ; 30) ;
une deuxième pluralité de plots métalliques (15 ; 38) sont préparés sur ledit deuxième substrat (13 ; 37) ;

au moins un plot de ladite première pluralité de plots (12 ; 31) est directement mis en contact, sans brasure, avec au moins un plot de ladite deuxième pluralité de plots métalliques (15 ; 38) ;
ladite première région de liaison non métallique est directement mise en contact avec ladite deuxième région de liaison non métallique ; et
ladite première région de liaison non métallique est liée sans adhésif à ladite deuxième région de liaison non métallique.

**3.** Procédé selon la revendication 1 ou la revendication 2, comprenant :

le polissage de chacune desdites première et deuxième régions de liaison non métalliques pour assurer une rugosité de surface inférieure à 15 Å ; et
la gravure de chacune desdites première et deuxième régions de liaison non métalliques après ledit polissage.

**4.** Procédé selon l'une quelconque des revendications 1 à 3, comprenant :

le polissage de chacune desdites première et deuxième régions de liaison non métalliques pour assurer une rugosité de surface non supérieure à 5 Å.

**5.** Procédé selon l'une quelconque des revendications 2 à 4, comprenant :

la formation d'au moins un plot de ladite première pluralité de plots métalliques (12 ; 31) pour avoir une surface supérieure s'étendant au-dessus d'une surface de ladite première région de liaison non métallique sur ledit premier substrat (10 ; 30) ; et
la formation d'au moins un plot de ladite deuxième pluralité de plots métalliques (15 ; 38) pour avoir une surface supérieure s'étendant au-dessus d'une surface de ladite région de liaison non métallique sur ledit deuxième substrat (10 ; 30).

**6.** Procédé selon la revendication 2, dans lequel ladite mise en contact directe dudit au moins un plot comprend la liaison de la première pluralité de plots métalliques (12 ; 31) à la deuxième pluralité de plots métalliques (15 ; 38).

**7.** Procédé selon l'une quelconque des revendications précédentes, comprenant :

le dépôt de plots métalliques sur le premier substrat (10 ; 30) après formation de ladite première région de liaison non métallique sur ledit premier substrat (10 ; 30).

**8.** Procédé selon la revendication 7, dans lequel le dépôt comprend le dépôt d'au moins l'un de Pt, Au, Pd et de leurs alliages.

**9.** Procédé selon l'une quelconque des revendications précédentes, comprenant en outre :

l'élimination de la contamination de surfaces desdites première et deuxième pluralités de plots métalliques (12, 15 ; 31, 38).

**10.** Procédé selon la revendication 9, dans lequel l'élimination comprend :

l'exposition desdits plots métalliques à un traitement par UV/ozone.

**11.** Procédé selon l'une quelconque des revendications 2 à 10, comprenant :

la formation des première et deuxième pluralités de plots métalliques ayant une épaisseur sensiblement plus petite que la distance de séparation entre certains adjacents desdits plots métalliques.

**12.** Procédé selon l'une quelconque des revendications 2 à 11, comprenant :

la formation desdites première et deuxième pluralités de plots métalliques (12, 15 ; 31, 38) selon une épaisseur inférieure à 1000 Å au-dessus d'une surface desdites première et deuxième régions de liaison non métalliques, respectivement.

**13.** Procédé selon quelconque des revendications 2 à 12, dans lequel ladite étape de mise en contact directe comprend la formation d'une zone non liée autour de certains mis en contact desdits plots métalliques (12, 15 ; 31, 38).

**14.** Procédé selon l'une quelconque des revendications précédentes, dans lequel la préparation d'un premier substrat (10 ; 30) et la préparation d'un deuxième substrat (13 ; 37) comprennent la formation d'une couche d'oxyde sur au moins l'un du premier substrat et du deuxième substrat ayant une rugosité de surface qui n'est pas supérieure à 5 Å et la formation de ladite couche d'oxyde comprend au moins l'une des étapes consistant à :

déposer la couche d'oxyde par dépôt en vapeur chimique ;
déposer la couche d'oxyde par pulvérisation cathodique ;
déposer la couche d'oxyde par un procédé au verre filé ;
former la couche d'oxyde par recuit thermique ; et déposer la couche d'oxyde par dépôt en vapeur chimique renforcé par plasma.

**15.** Procédé selon la revendication 14, comprenant :

le polissage de ladite couche d'oxyde.

**16.** Procédé selon la revendication 15, comprenant :

la gravure de ladite couche d'oxyde après ledit polissage.

**17.** Procédé selon la revendication 16, comprenant :

l'exposition de ladite couche d'oxyde à un plasma d'oxygène.

**18.** Procédé selon l'une quelconque des revendications 2 à 17, comprenant :

la formation d'une première couche de liaison sur ledit premier substrat (10 ; 30) pour couvrir ladite première pluralité de plots métalliques (12 ; 31) ;
la formation d'une ouverture dans ladite première couche de liaison par-dessus certains choisis de ladite première pluralité de plots métalliques (12 ; 31) ;
la formation d'une deuxième couche de liaison sur ledit deuxième substrat (13 ; 37) ;
la formation de ladite deuxième pluralité de plots métalliques (15 ; 38) sur ladite deuxième couche de liaison, ladite deuxième pluralité de plots métalliques (15 ; 38) correspondant à des ouvertures de ladite première couche de liaison ; et
la mise en contact directe desdites première et deuxième couches de liaison.

**19.** Procédé selon l'une quelconque des revendications 2 à 18, dans lequel la formation de ladite première pluralité de plots métalliques (12 ; 31) comprend :

la formation d'une couche parmi une couche d'aluminium, de cuivre et d'alliage d'aluminium ; et
la formation d'une couche parmi une couche d'Au, de Pd et de Pt sur ladite couche.

**20.** Procédé selon l'une quelconque des revendications précédentes, comprenant :

l'exposition desdits premier et deuxième substrats (10, 13 ; 30, 37) a un plasma d'oxygène ; et
l'élimination d'une couche d'oxyde desdits plots métalliques (12, 15 ; 31, 38).

**21.** Procédé selon l'une quelconque des revendications 2 à 20, dans lequel :

la préparation dudit premier substrat (10, 30) comprend la formation d'une pluralité de troisièmes substrats, chacun plus petit que ledit deuxième substrat (13 ; 37) et chacun ayant au moins un troisième plot métallique ;
la mise en contact dudit au moins un plot comprend la mise en contact d'un troisième plot métallique de chacun desdits troisièmes substrats avec l'un de ladite deuxième pluralité de plots métalliques (15 ; 38) ;
la mise en contact directe comprend la mise en contact d'une troisième région de liaison non métallique de chacun desdits troisièmes substrats avec ladite deuxième région de liaison non métallique dudit deuxième substrat ; et

ladite liaison comprend la liaison desdites troisièmes régions de liaison non métalliques à ladite deuxième région de liaison non métallique.

**22.** Procédé selon la revendication 2, 3, 4, 5, 6 ou 8, dans lequel chacune de la préparation dudit premier substrat (10 ; 30) et de la préparation dudit deuxième substrat (13 ; 37) comprend :

la formation d'une couche de dioxyde de silicium ;
la configuration de ladite couche de dioxyde de silicium ;
la formation de trous d'interconnexion dans ladite couche de dioxyde de silicium ; et
la formation d'une structure métallique dans lesdits trous d'interconnexion.

**23.** Procédé selon l'une quelconque des revendications 2 à 22, comprenant :

la formation d'une première couche d'oxyde sur ledit premier substrat (10 ; 30) ;
la formation de ladite première pluralité de plots métalliques (12 ; 31) s'étendant au-dessus d'une surface de ladite première couche d'oxyde ;
la formation d'une deuxième couche d'oxyde sur ledit deuxième substrat (13 ; 37) ; et
la formation de ladite deuxième pluralité de plots métalliques (15 ; 38) noyés en dessous d'une surface de ladite deuxième couche d'oxyde.

**24.** Procédé selon l'une quelconque des revendications 1 à 23, comprenant :

la formation d'un vide ou la disposition d'un matériau déformable en dessous d'au moins l'un de ladite première pluralité de plots métalliques (12, 15 ; 31, 38).

**25.** Procédé selon la revendication 24, comprenant :

la déformation d'un matériau en dessous dudit au moins un plot de manière qu'il s'étende dans ledit vide.

**26.** Procédé selon l'une quelconque des revendications 2 à 24, comprenant :

la réduction d'une zone non liée autour d'au moins l'un desdites première et deuxième pluralités de plots métalliques (12, 15 ; 31, 38) en utilisant un vide ménagé à proximité de ladite au moins une desdites première et deuxième pluralités de plots métalliques (12, 15 ; 31, 38) ou en disposant un matériau déformable en dessous d'elle.

**27.** Procédé selon la revendication 26, comprenant :

la réduction d'épaisseur dudit matériau dans une zone située en dessous dudit au moins un de ladite première pluralité de plots métalliques (12, 31).

**28.** Procédé selon la revendication 25, comprenant :

la disposition d'un matériau déformable de faible valeur K en dessous dudit au moins un de ladite première pluralité de plots métalliques (12, 31).

**29.** Procédé selon la revendication 28, comprenant :

la réduction d'épaisseur dudit matériau de faible valeur K dans une zone située en dessous dudit au moins un de ladite première pluralité de plots métalliques.

**30.** Procédé selon l'une quelconque des revendications précédentes, comprenant :

la formation d'une liaison chimique entre ladite première région de liaison non métallique et ladite deuxième région de liaison non métallique à peu près à la température ambiante.

**31.** Procédé selon l'une quelconque des revendications précédentes, comprenant :

la formation de ladite liaison chimique entre ladite première région de liaison non métallique et ladite deuxième région de liaison non métallique sans appliquer de pression externe au cours de la liaison.

**32.** Procédé selon l'une quelconque des revendications précédentes, comprenant :

la formation d'au moins l'un desdites première et deuxième pluralités de plots métalliques (12, 31 ; 31, 38) de manière a avoir une surface supérieure sensiblement coplanaire avec une surface supérieure desdites première et deuxième régions de liaison non métalliques, respectivement.

**33.** Procédé selon l'une quelconque des revendications 2 à 32, comprenant :

la formation de ladite première pluralité de plots métalliques (12, 31) dans ladite première région de liaison non métallique ; et
le polissage chimio-mécanique de ladite première pluralité de plots métalliques et de ladite première région de liaison non métallique.

**34.** Procédé selon l'une quelconque des revendications 2 à 33, comprenant :

le chauffage dudit au moins un plot de ladite première pluralité de plots métalliques (12, 31) et dudit au moins un plot de ladite deuxième pluralité de plots métalliques (15, 38) après ladite étape de mise en contact directe de ladite première région de liaison non métallique avec ladite deuxième région de liaison non métallique.

**35.** Procédé selon l'une quelconque des revendications précédentes, dans lequel :

la préparation dudit premier substrat (10 ; 30) comprend la préparation d'une filière ayant une partie de substrat.

**36.** Procédé selon la revendication 21, dans lequel :

la formation de ladite pluralité de troisièmes substrats comprend la formation d'une pluralité de filières ayant chacune une partie de substrat.

**37.** Procédé selon la revendication 1, comprenant les étapes consistant à :

préparer une pluralité de premiers substrats (10 ; 30) chacun ayant un premier plot métallique (12, 31) et une première région de liaison non métallique proche dudit premier plot métallique ;
préparer ledit deuxième substrat (13, 37) ayant une pluralité de deuxièmes plots métalliques (35, 38) et une deuxième région de liaison non métallique proche de chacun desdits deuxièmes plots métalliques (35, 38) ;
amener ledit premier plot métallique (12, 31) de chacun de ladite pluralité de premiers substrats (10 ; 30) en contact physique avec l'un desdits deuxièmes plots métalliques (35, 38) ;
amener chacune desdites premières régions de liaison non métalliques en contact physique avec l'une desdites deuxièmes régions de liaison non métalliques ; et
former une liaison chimique entre lesdites premières régions de liaison non métalliques et lesdites deuxièmes régions de liaison non métalliques.

**38.** Procédé selon la revendication 37, dans lequel :

la préparation de ladite pluralité de premiers substrats comprend la formation d'une pluralité de filières ayant chacune une partie de substrat.

**39.** Procédé selon la revendication 25, comprenant :

la déformation du matériau en dessous dudit au moins un plot.

**40.** Procédé selon la revendication 2, comprenant :

le chauffage dudit au moins un plot de ladite première pluralité de plots métalliques (12, 31) et dudit au moins un plot de ladite deuxième pluralité de plots métalliques (15, 38) après ladite étape de mise en contact directe de ladite première région de liaison non métallique avec ladite deuxième région de liaison non métallique pour former une connexion entre lesdites au moins un plot de ladite première et de ladite deuxième pluralité de plots métalliques.

**41.** Procédé selon la revendication 2, comprenant :

la génération d'une pression entre le au moins un plot de ladite première pluralité de plots métalliques (12 ; 31) et le au moins un plot de ladite deuxième pluralité de plots métalliques (15 ; 38) pour lier la première et la deuxième région de liaison non métalliques.

**42.** Procédé selon la revendication 2, 3, 4, 5, 6 ou 8, dans lequel chacune de la préparation dudit premier substrat (10 ; 30) et de la préparation dudit deuxième substrat n(13 ; 37) comprend :

la formation d'une couche de nitrure de silicium ;
la configuration de ladite couche de nitrure de silicium ;
la formation de trous d'interconnexion dans ladite couche de nitrure de silicium ; et
la formation d'une structure métallique dans lesdits trous d'interconnexion.

FIG. 1a

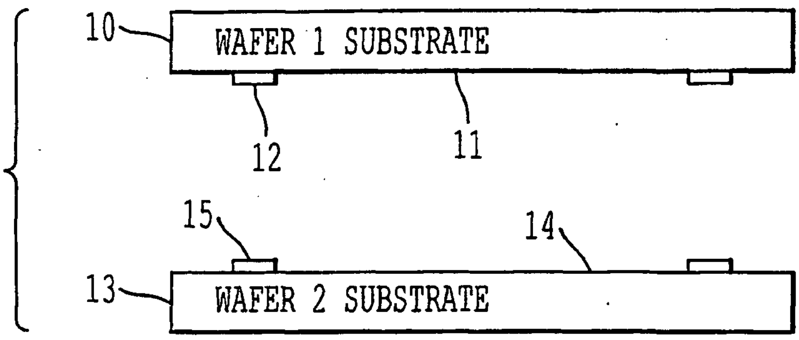


FIG. 1b

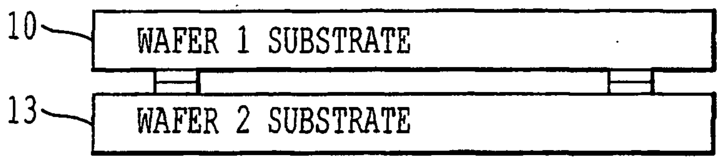


FIG. 1c

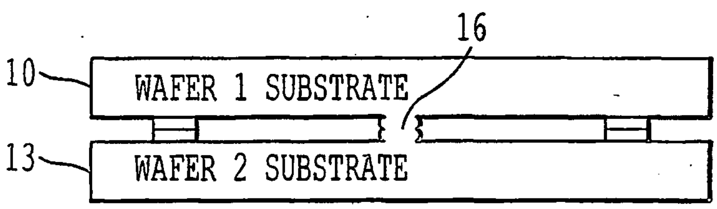


FIG. 1d

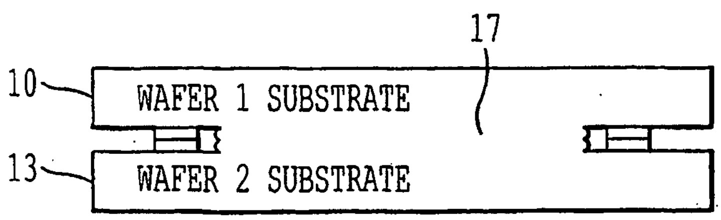

FIG. 2a

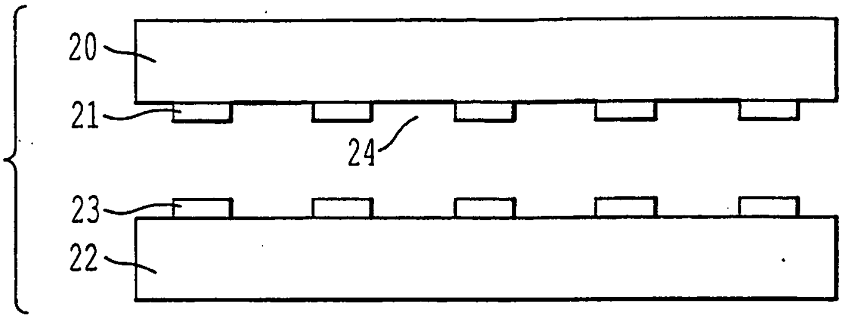


FIG. 2b

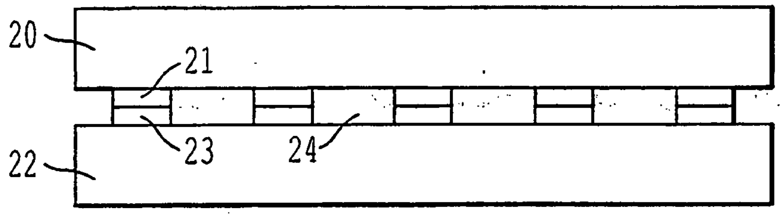


FIG. 2c

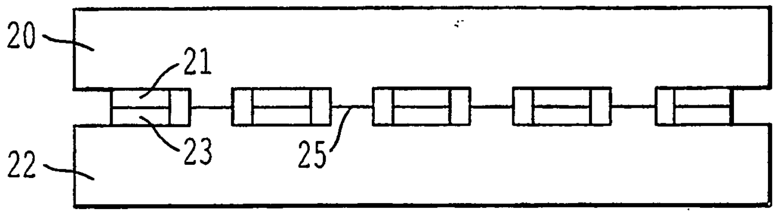


FIG. 4d

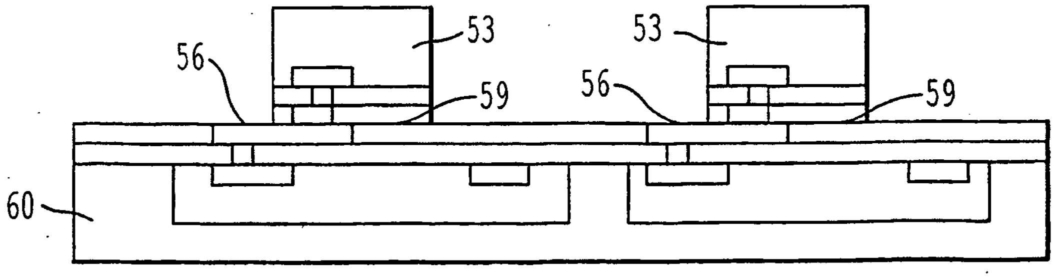

*FIG. 2d*

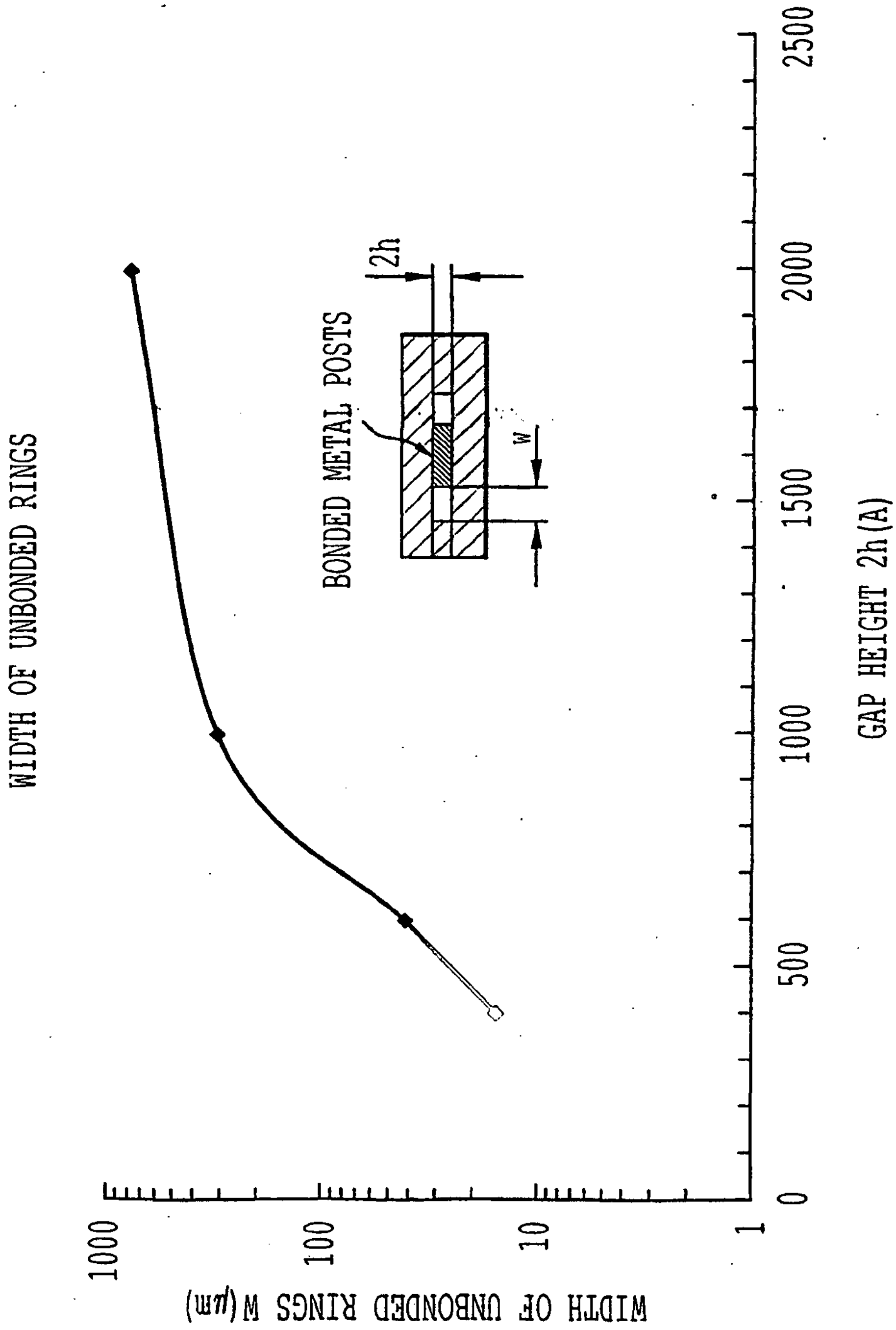
WIDTH OF UNBONDED RINGS
BONDED METAL POSTS
2h
W
WIDTH OF UNBONDED RINGS W(μm)
1000
100
10
1
0
500
1000
1500
2000
2500
GAP HEIGHT 2h(A)

FIG. 3a

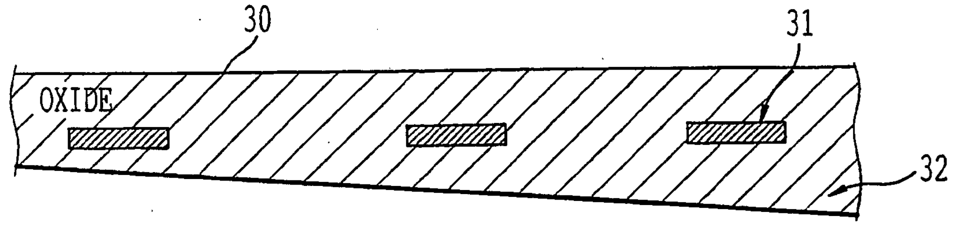


FIG. 3b

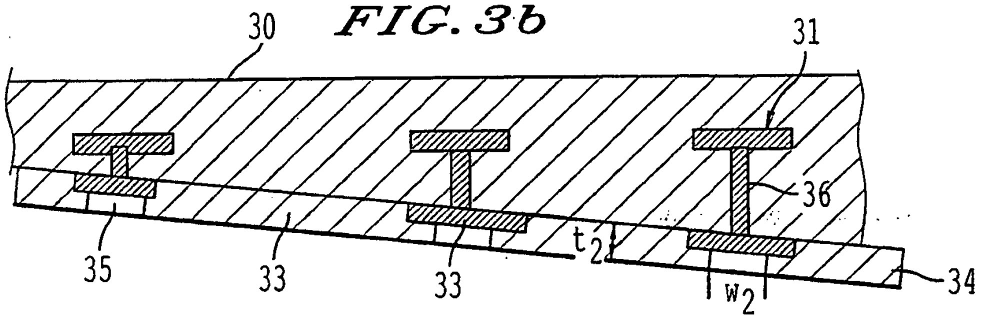


FIG. 3c

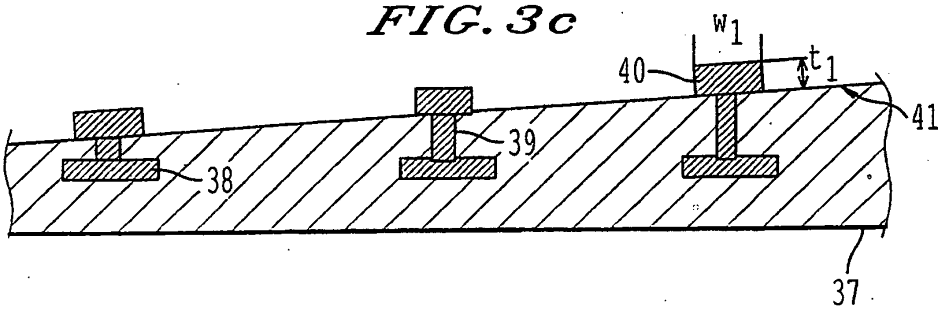


FIG. 3d

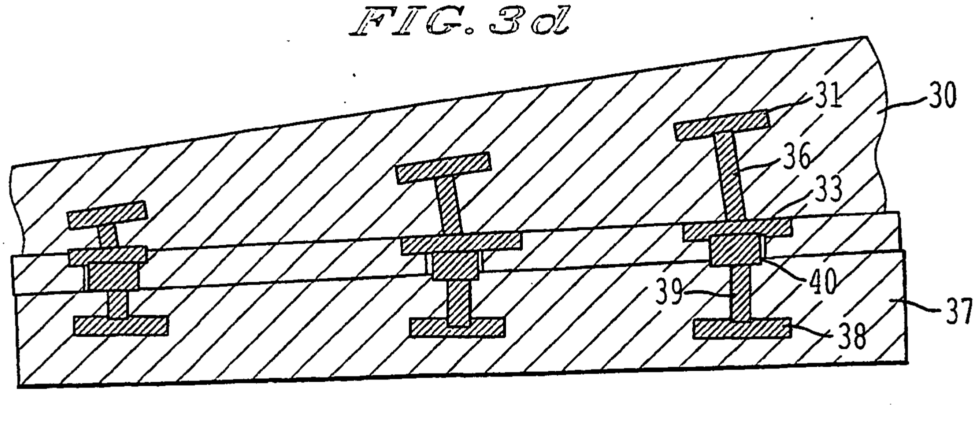

FIG. 4a

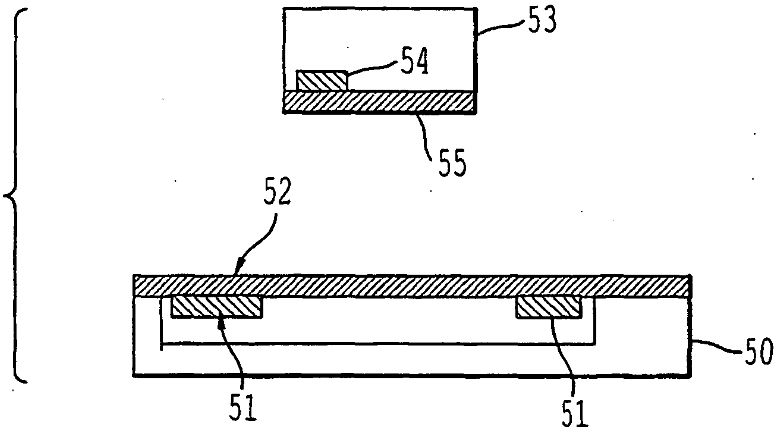


FIG. 4b

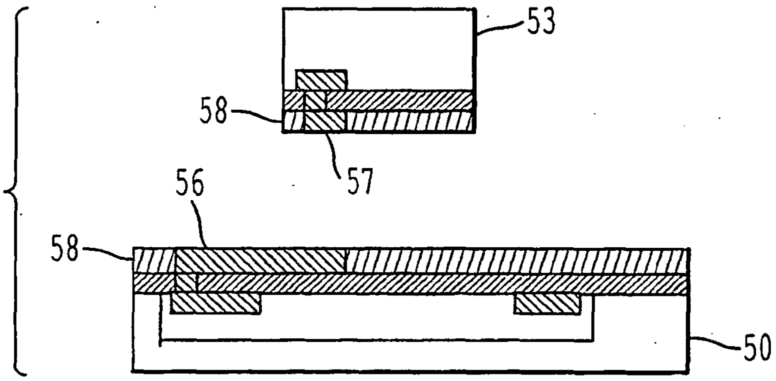


FIG. 4c

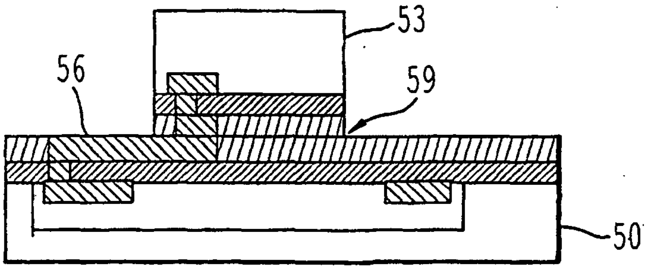

FIG. 5a

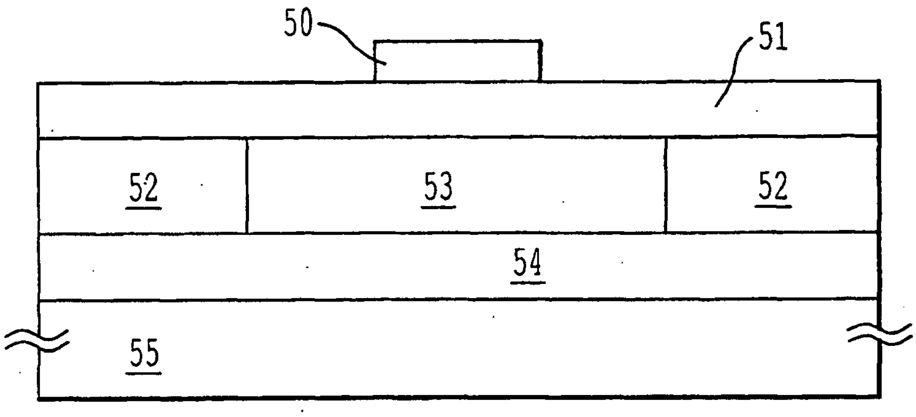


FIG. 5b

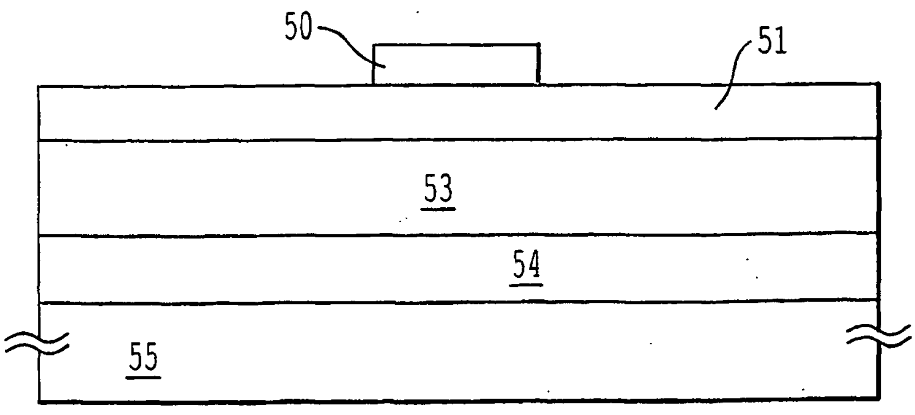

FIG. 5c

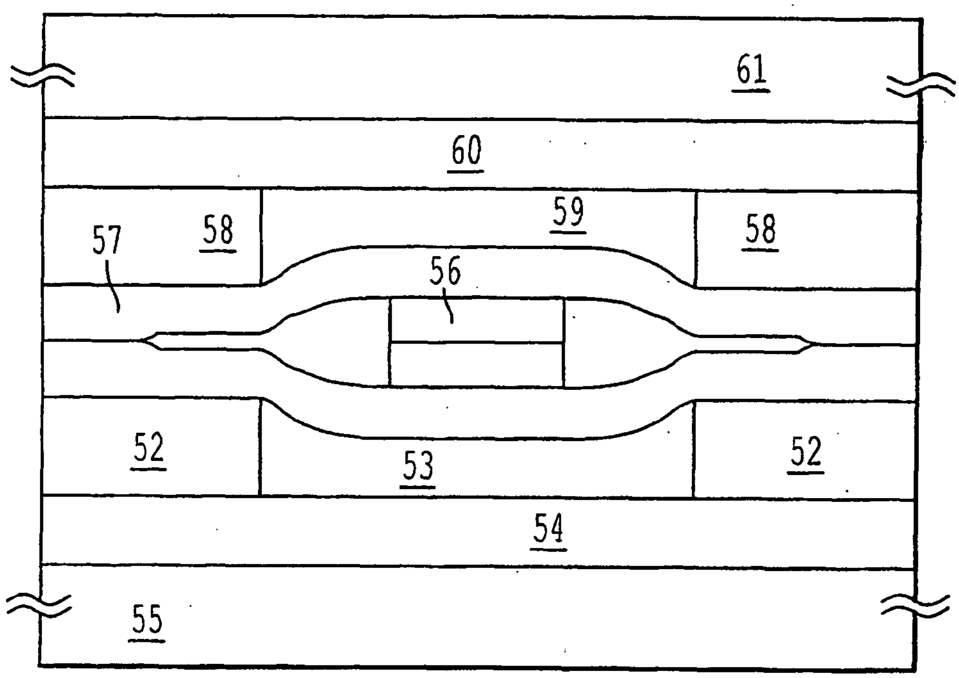

FIG. 6a

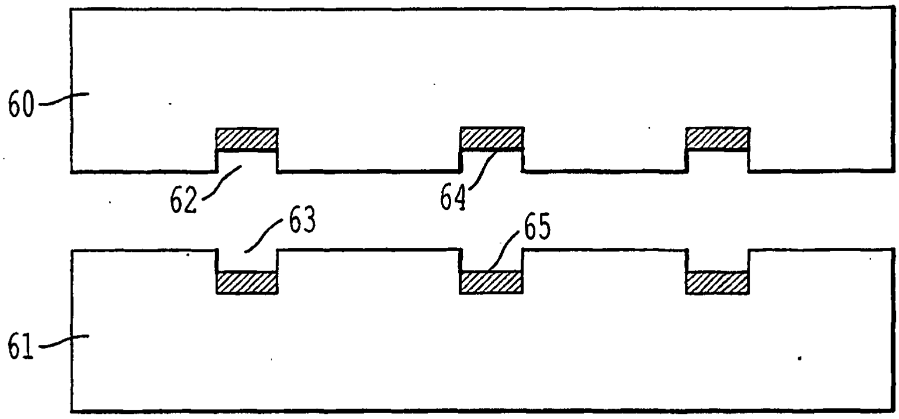


FIG. 6b

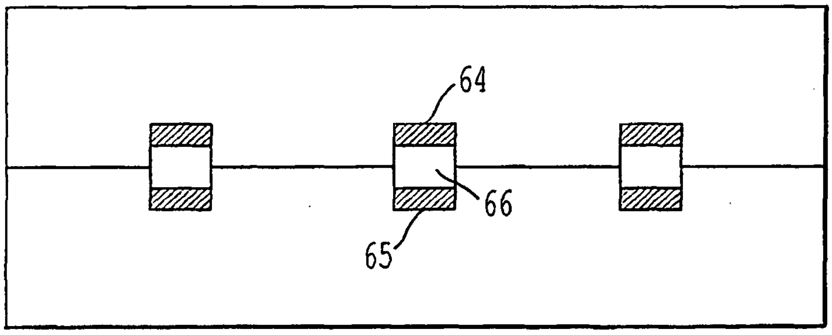


FIG. 6c

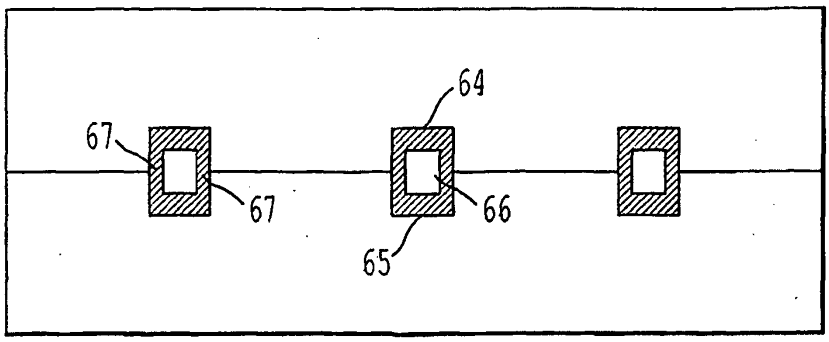

FIG. 7a

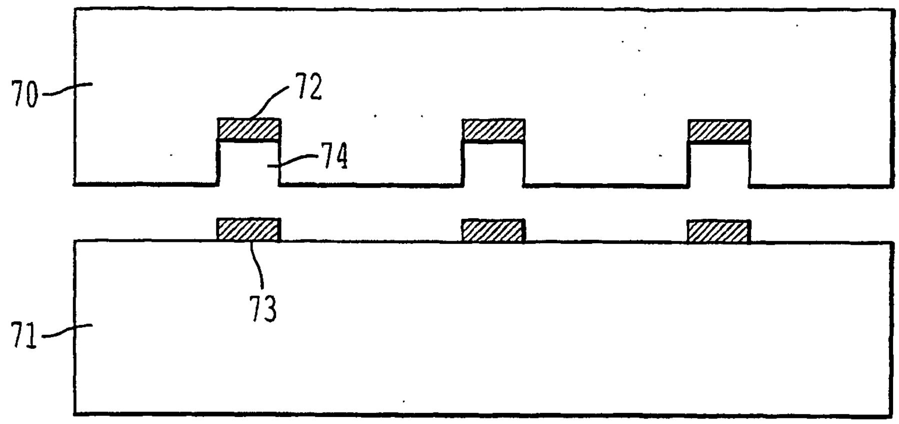


FIG. 7b

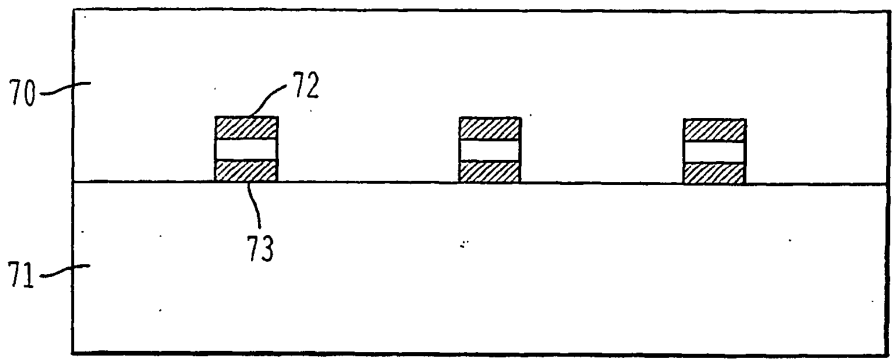


FIG. 7c

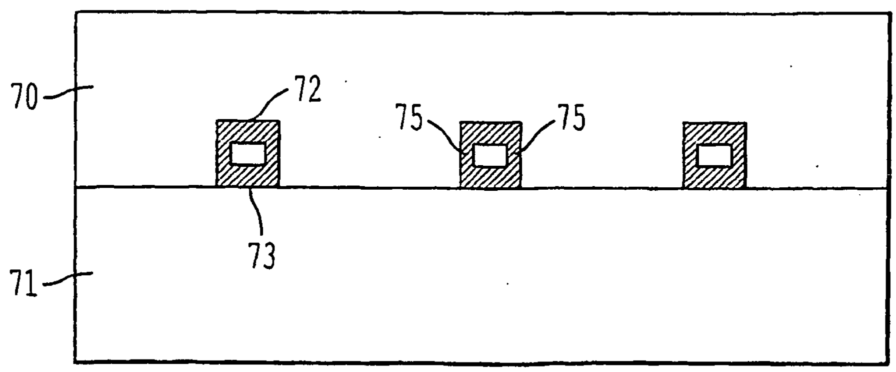

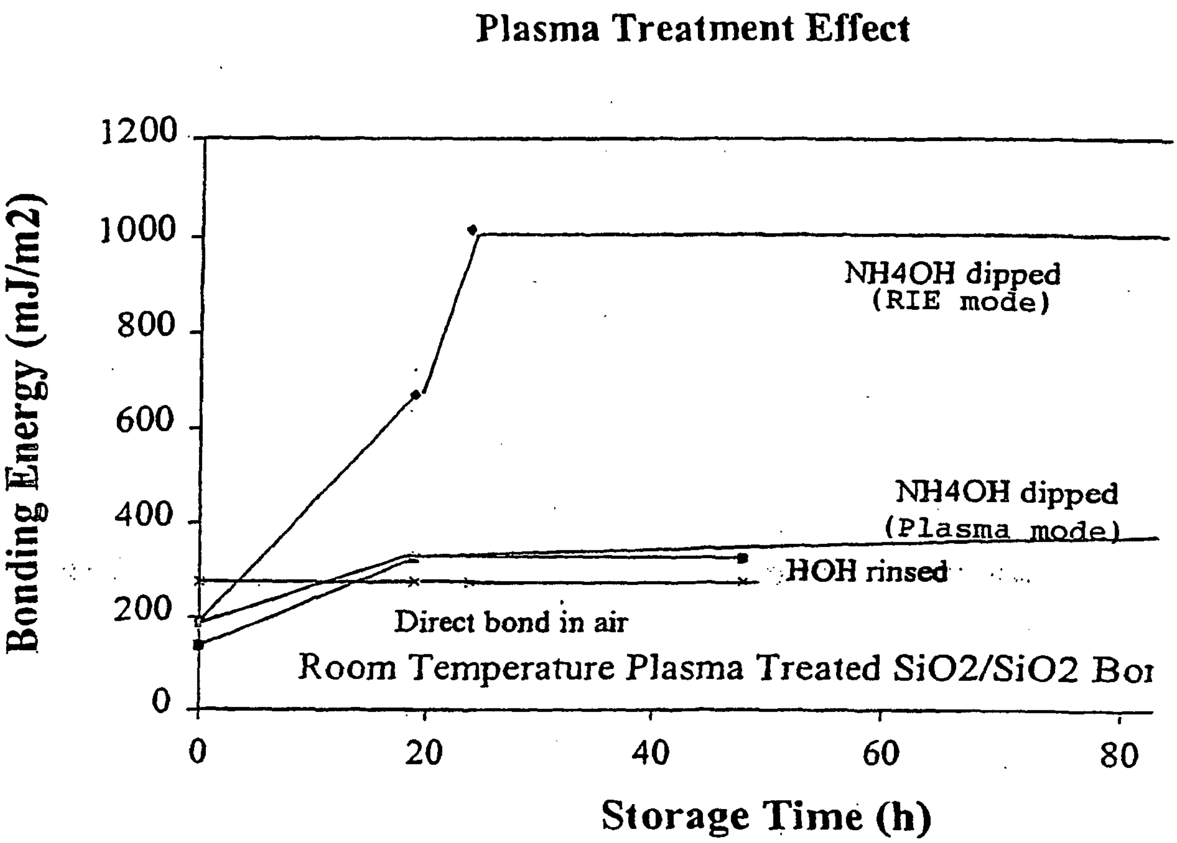
Plasma Treatment Effect
Bonding Energy (mJ/m2)
1200
1000
800
600
400
200
0
NH4OH dipped
(RIE mode)
NH4OH dipped
(Plasma mode)
HOH rinsed
Direct bond in air
Room Temperature Plasma Treated SiO2/SiO2 Bo
0
20
40
60
80
Storage Time (h)

FIG. 8

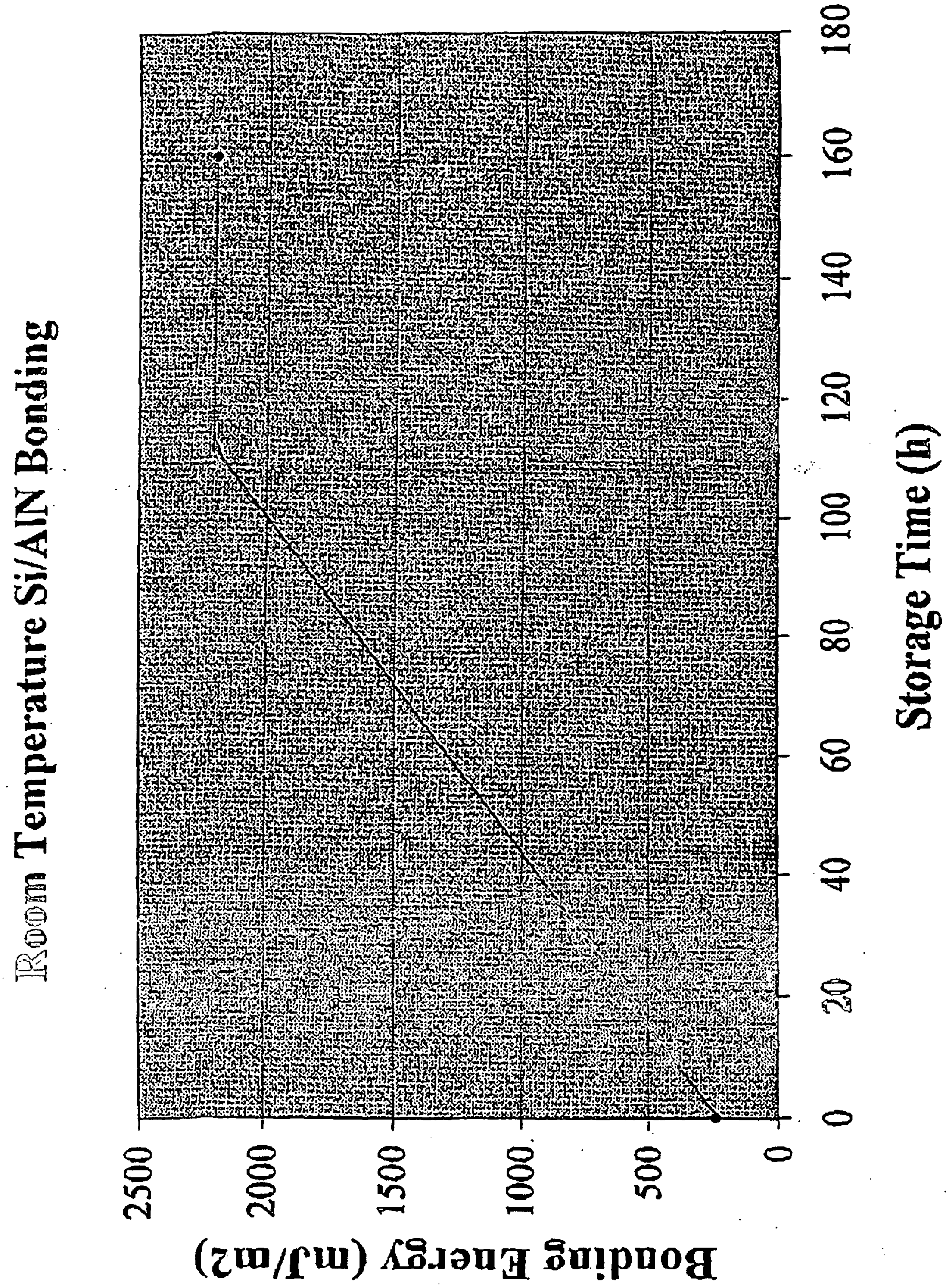
Room Temperature Si/AlN Bonding
Bonding Energy (mJ/m2)
2500
2000
1500
1000
500
0
0
20
40
60
80
100
120
140
160
180
Storage Time (h)

FIG. 9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 4818728 A
- US 5563084 A
- US 20020173120 A1
- US 09410054 B
- US 09505283 B
- US 09532886 B

### Non-patent literature cited in the description


- **Y. HAYASHI ; S. WADA ; K. KAJIYANA ; K. OYAMA ; R. KOH ; S TAKAHASHI ; T. KUNIO.** *Symp. VLSI Tech. Dig.,* 1990, 95
- **Q.-Y. TONG ; U. GÖSELE.** Semiconductor Wafer Bonding: Science and Technology. John Wiley & Sons, 1999
- **M.A. SCHMIDT.** *Proc. IEEE,* 1998, vol. 86 (8), 1575
- **Y. LI ; R.W. BOWER ; I. BENCUYA.** *Jpn. J. Appl. Phys.,* 1988, vol. 37, L1068
- **B. ASPAR ; E. JALAGUIER ; A. MAS ; C. LOCATELLI ; O. RAYSSAC ; H. MORICEAN ; S. POCAS ; A. PAPON ; J. MICHASUD ; M. BRUEL.** *Electon. Lett.,* 1999, vol. 35, 12
- **M. HIZUKURI ; N. WATANABE ; T. ASANO.** *Jpn. J. Appl. Phys.,* 2001, vol. 40, 3044
- **T. SUGA.** *Proc. The 2nd Intl. Symposium on semiconductor wafer bonding, the Electrochemical Soc. Proc.,* 1993, vol. 93-29, 71
- **T. SHIMATSU ; R.H. MOLLEMA ; D. MONSMA ; E.G. KEIM ; J.C. LODDER.** *J. Vac. Sci. Technol. A,* 1998, vol. 16 (4), 2125
- **U. GOESELE ; Q.-Y. TONG.** *Proc. The 2nd Intl. Symposium on semiconductor wafer bonding, the Electrochemical Soc. Proc.,* 1993, vol. 93-29, 395
- **T. SHIMATSU ; R.H. MOLLEMA ; D. MONSMA ; E.G. KEIM ; J.C. LODDER.** *IEEE Tran. Magnet.,* 1997, vol. 33, 3495
- **MAISSEL ; GLANG.** Handbook of Thin Film Technology. 1983, 12-24